(19) Europäisches Patentamt / European Patent Office / Office européen des brevets

(11) **EP 3 790 013 B1**

(12) **EUROPEAN PATENT SPECIFICATION**

(45) Date of publication and mention of the grant of the patent:
**02.04.2025 Bulletin 2025/14**

(21) Application number: **20192234.1**

(22) Date of filing: **21.08.2020**

(51) International Patent Classification (IPC):
**G11C 27/02** *(2006.01)* **H03M 1/12** *(2006.01)*
**H03K 19/20** *(2006.01)*

(52) Cooperative Patent Classification (CPC):
**G11C 27/024;** H03K 19/20; H03M 1/122;
H03M 1/1245

(54) **CIRCUITRY FOR LOW INPUT CHARGE ANALOG TO DIGITAL CONVERSION**

SCHALTUNG ZUR ANALOG-DIGITAL-WANDLUNG MIT NIEDRIGER EINGANGSLADUNG

CIRCUITS POUR CONVERSION ANALOGIQUE-NUMÉRIQUE À FAIBLE CHARGE D'ENTRÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.09.2019 US 201916560683**

(43) Date of publication of application:
**10.03.2021 Bulletin 2021/10**

(73) Proprietor: **STMicroelectronics International N.V.**
**1228 Plan-les-Ouates, Geneva (CH)**

(72) Inventors:
• **NARWAL, Mr. Rajesh**
**201301 Greater Noida (IN)**
• **BENJWAL, Mr. Kavindu Shekhar**
**201301 Noida (IN)**

(74) Representative: **Buzzi, Notaro & Antonielli d'Oulx S.p.A.**
**Corso Vittorio Emanuele II, 6**
**10123 Torino (IT)**

(56) References cited:
**US-A1- 2002 036 576    US-B1- 7 564 394**

## Description

TECHNICAL FIELD

This disclosure is related to the field of analog to digital conversion, and in particular, to a circuit for reducing the input charge provided from an analog input to a sampling capacitor of an analog to digital converter.

BACKGROUND

Analog to digital conversion is widely used in applications involving numerous sensors, such as automotive applications. In some conventional forms of analog to digital conversion, an analog source (such as a sensor) provides an input charge to a sampling capacitor, and the charge accumulated, hence the voltage sampled on the sampling capacitor over a sampling period is converted to a digital value.

It is desired to reduce the input charge so that voltage drop across an input filter of the analog to digital converter is reduced, enabling an increase in sampling rate. Existing technology accomplishes this goal using rail to rail buffers to sample the input voltage. While this eliminates the concern about input charge, such buffers consume a large amount of on-chip area and have high power consumption, particularly with a high sampling rate. Particularly for cases where there are numerous analog input sources, the use of such buffers becomes too costly in terms of area and power consumption.

Therefore, further development in this area is needed.

In this field, document US 7,564,394 B1 discloses a buffer for the input to an analog to digital (A/D) converter that operates in two stages. During the first stage, the input is not provided directly to the A/D converter; rather, a buffered output which corresponds to the input is provided to the A/D converter so as to pre-charge the sampling capacitor of the A/D converter to a value that is substantially close to the input. In the second stage, the input is provided directly to the A/D converter, which charges its sampling capacitor to the value of the input. Because the sampling capacitor is pre-charged to a value that is substantially close to the input, and because the sampling capacitor is charged to this value through a buffer, reflections back into the input which otherwise might have been caused by a difference between the value stored on the sampling capacitor and the input are largely avoided.

The buffer disclosed in document US 7,564,394 B1 includes a sampling capacitor. The buffer includes first and second circuit paths, in which the first circuit path connects the input to the A/D converter through a first switch. The second circuit path includes a buffer which provides a buffered output corresponding to the input, and further includes a second switch which connects the buffered output to the A/D converter. A switch controller, such as a circuit which generates timing signals, provides switching control over the first and second switches. During a sampling operation of the sampling capacitor in the A/D converter, the switch controller operates in a first stage where the first switch is open and the second switch is closed, followed by a second stage where the first switch is closed. As a consequence, during the first stage the input is not connected to the sampling capacitor of the A/D converter; rather, the buffered output is provided to the sampling capacitor, which pre-charges the sampling capacitor to a value substantially close to the input. Thereafter, in the second stage, the input is connected to the sampling capacitor of the A/D converter. During the second stage, the second switch (corresponding to the buffered output) may be opened. A third switch may be provided, which discharges the sampling capacitor during a period of time prior to the first and second stages.

Document US 2002/0036576 A1 is also of interest for the instant invention, insofar as it discloses an analog switch and a sample-and-hold circuit for an A/D converter. In particular, the analog switch can be used as an input circuit in a multiplexer that feeds the sample-and-hold circuit, or as an input circuit of the sample-and-hold circuit. A voltage follower amplifier is provided in parallel to the analog switch so as to pre-charge a stray capacitance at the output node of the analog switch to a voltage close to the input voltage of the analog switch, before the analog switch is closed. When the analog switch is closed, the voltage follower amplifier is deactivated.

The voltage follower amplifier disclosed in document US 2002/0036576 A1 is constituted by a differential input stage, an output stage, and a bias stage. The differential input stage is constructed of a general-purpose differential amplifying circuit. This differential amplifying circuit is constituted by differential MOSFETs, the sources of which are commonly connected to each other; active load MOSFETs which are connected to the drain sides of the differential MOSFETs; and a further MOSFET connected between the ground point and the commonly-connected sources of the differential MOSFETs, the further MOSFET used for a current source. The input voltage of the analog switch is applied to a gate terminal of one of the differential MOSFETs. The output stage is arranged by an output MOSFET in which a potential of an inverting-sided output node of the differential input stage is received by the gate thereof; an MOSFET used for a current source, which is connected in series to the output MOSFET; and a switch MOSFET. This switch MOSFET is connected between the gate of the output MOSFET and the power supply voltage, and is turned ON/OFF in response to a control signal.

SUMMARY

Aspects disclosed herein are directed to input circuits for multiplexers according to independent claims 1 and 5.

The input circuit includes a first analog input node and a capacitive output node. A first control circuit comprises discharge circuitry configured to discharge the capacitive output node to ground during a first period of time beginning in response to a start of a sampling cycle of an analog to digital converter where input to the analog to digital converter is driven by output from the multiplexer. A second control circuit comprises level shifting circuitry configured to charge the capacitive output node to a voltage at the first analog input node during a second period of time beginning in response to expiration of the first period of time. The level shifting circuitry includes a first p-channel transistor having a drain connected to ground, a source connected to a first node, and a gate connected to the first analog input node; and a second n-channel transistor having a source connected to the capacitive output node and a gate connected to a second node. A first channel selection switch closes to connect the first analog input node to the capacitive output node to thereby drive the capacitive output node to the voltage at the first analog input node, the first channel selection switch being closed in response to expiration of the second period of time. The first channel selection switch opens to disconnect the first analog input node from the capacitive output node at an end of the sampling cycle of the analog to digital converter. The input circuit further comprises a control signal generator configured to assert a second control signal, for the first period of time, in response to the start of the sampling cycle of the analog to digital converter; deassert the second control signal in response to the expiration of the first period of time; assert a first control signal, for the second period of time, in response to the expiration of the first period of time; and deassert the first control signal in response to the expiration of the second period of time. The level shifting circuitry further comprises a first n-channel transistor having a drain connected to the second node, a source connected to ground, and a gate connected to the first control signal; a transmission gate configured to connect the first node to the second node in response to assertion of the first control signal; and a second p-channel transistor having a drain connected to a drain of the second n-channel transistor, a source connected to a supply voltage, and a gate connected to the first control signal.

Another aspect disclosed herein is directed to another input circuit for a multiplexer. The input circuit includes a first analog input node and a capacitive output node. A first control circuit comprises charge circuitry configured to charge the capacitive output node to a supply voltage during a first period of time beginning in response to a start of a sampling cycle of an analog to digital converter where input to the analog to digital converter is driven by output from the multiplexer. A second control circuit comprises level shifting circuitry configured to discharge the capacitive output node to a voltage at the first analog input node during a second period of time beginning in response to expiration of the first period of time. The level shifting circuitry includes a first n-channel transistor having a drain connected to the supply voltage, a source connected to a first node, and a gate connected to the first analog input node; and a second p-channel transistor having a source connected to the capacitive output node and a gate connected to a second node. A first channel selection switch closes to connect the first analog input node to the capacitive output node to thereby drive the capacitive output node to the voltage at the first analog input node, the first channel selection switch being closed in response to expiration of the second period of time. The first channel selection switch opens to disconnect the first analog input node from the capacitive output node at an end of the sampling cycle of the analog to digital converter. The input circuit further comprises a control signal generator configured to assert a second control signal, for the first period of time, in response to the start of the sampling cycle of the analog to digital converter; deassert the second control signal in response to the expiration of the first period of time; assert a first control signal, for the second period of time, in response to the expiration of the first period of time; and deassert the first control signal in response to the expiration of the second period of time. The level shifting circuitry further comprises a first p-channel transistor having a source connected to the supply voltage, a drain connected to the second node, and a gate connected to a complement of the first control signal; a transmission gate configured to connect the first node to the second node in response to assertion of the first control signal; and a second n-channel transistor having a drain connected to a drain of the second p-channel transistor, a source connected to ground, and a gate connected to the complement of the first control signal.

Another aspect disclosed herein, not in accordance with the invention as claimed, is directed to an input circuit for an analog to digital converter. The input circuit includes a first channel selection switch that closes to connect a first analog input node to an intermediate node to thereby charge the intermediate node to a voltage at the first analog input node, the first channel selection switch being closed during a first period of time beginning in response to a start of a sampling cycle of the analog to digital converter. A capacitive node is connected to an output node. Discharge circuitry is connected between the first channel selection switch and the output node and configured to discharge the capacitive node during the first period of time. Level shifting circuitry is configured to charge the capacitive node to a voltage at the intermediate node less a threshold voltage of a first transistor of the level shifting circuitry, during a second period of time beginning in response to expiration of the first period of time. A selection switch closes to connect the intermediate node to the output node to thereby charge the output node to the voltage at the intermediate node, the selection switch being closed in response to expiration of the second period of time. The selection switch opens to disconnect the intermediate node from the output node at an end of the sampling cycle of the analog to digital converter.

A further aspect disclosed herein, not in accordance with the invention as claimed, is directed to an input circuit for an analog to digital converter. The input circuit includes a first channel selection switch that closes to connect a first analog input node to an intermediate node to thereby charge the intermediate node to a voltage at the first analog input node, the first channel selection switch being closed during a first period of time beginning in response to a start of a sampling cycle of the analog to digital converter. A capacitive node is connected to an output node. Charge circuitry is connected between the first channel selection switch and the output node and configured to charge the capacitive node to a supply voltage during the first period of time. Level shifting circuitry is configured to discharge the capacitive node to a voltage at the intermediate node plus a threshold voltage of a first transistor of the level shifting circuitry, during a second period of time beginning in response to expiration of the first period of time. A selection switch closes to connect the intermediate node to the output node to thereby discharge the output node to the voltage at the intermediate node, the selection switch being closed in response to expiration of the second period of time. The selection switch opens to disconnect the intermediate node from the output node at an end of the sampling cycle of the analog to digital converter.

An additional aspect not in accordance with the invention as claimed is directed to an input circuit for an analog to digital converter. The input circuit includes a first channel selection switch that closes to connect a first analog input node to an intermediate node to thereby charge the intermediate node to a voltage at the first analog input node, the first channel selection switch being closed during a first period of time beginning in response to a start of a sampling cycle of the analog to digital converter. A capacitive node is connected to an output node. A first control circuit is connected between the first channel selection switch and the output node and configured to set a charge at the capacitive node to a desired voltage during the first period of time. A second control circuit is configured to set a charge at the capacitive node to a voltage at the intermediate node modified by a mismatch voltage resulting from mismatch in threshold voltages between a first transistor connected to the intermediate node and a second transistor connected to the output node, during a second period of time beginning in response to expiration of the first period of time. A selection switch closes to connect the intermediate node to the output node to thereby charge the output node to the voltage at the intermediate node, the selection switch being closed in response to expiration of the second period of time. The selection switch opens to disconnect the intermediate node from the output node at an end of the sampling cycle of the analog to digital converter.

BRIEF DESCRIPTION OF THE DRAWINGS

FIG. 1 is a block diagram of a multiplexing input circuit for an analog to digital converter, in accordance with this disclosure.
FIG. 2 is a schematic diagram of a sample level shifting circuit such as may be used in the multiplexing input circuit of FIG. 1.
FIG. 3 is a timing diagram of the level shifting circuit of FIG. 2 in operation.
FIG. 4 is a schematic diagram of an alternative sample level shifting circuit such as may be used in the multiplexing input circuit of FIG. 1.
FIG. 5 is a timing diagram of the level shifting circuit of FIG. 4 in operation.
FIG. 6 is a schematic diagram of another multiplexing input circuit for an analog to digital converter, not in accordance with the invention as claimed.
FIG. 7 is a timing diagram of the multiplexing input circuit of FIG. 6 in operation.
FIG. 8 is a schematic diagram of yet another multiplexing input circuit for an analog to digital converter, not in accordance with the invention as claimed.
FIG. 9 is a timing diagram of the multiplexing input circuit of FIG. 8 in operation.
FIG. 10 is a schematic diagram of a further multiplexing input circuit for an analog to digital converter, not in accordance with the invention as claimed.
FIG. 11 is a timing diagram of the multiplexing input circuit of FIG. 10 in operation.
FIG. 12 is a schematic diagram of an additional multiplexing input circuit for an analog to digital converter, not in accordance with the invention as claimed.
FIG. 13 is a timing diagram of the multiplexing input circuit of FIG. 12 in operation.
FIG. 14 is a schematic diagram of input switches, such as may be used with the multiplexing input circuits of FIGS. 2, 4, 6, 8, 10, and 12.
FIG. 15 is first a graph showing input charge across different input voltages, in accordance with the designs of this disclosure.
FIG. 16 is a second graph showing input charge across different input voltages, in accordance with the designs of this disclosure.

DETAILED DESCRIPTION

The following disclosure enables a person skilled in the art to make and use the subject matter disclosed herein. The general principles described herein may be applied to embodiments and applications other than those detailed above without departing from the scope of this disclosure.
The scope of the present invention is therefore only limited by the appended claims.

As used in the claims, the word "asserted" means that a signal has the logic level required to turn on the component to which it is passed. For example, an "asserted" signal turns on a transistor, regardless of whether the transistor is n-channel or p-channel; similarly, an "asserted" signal closes a switch.

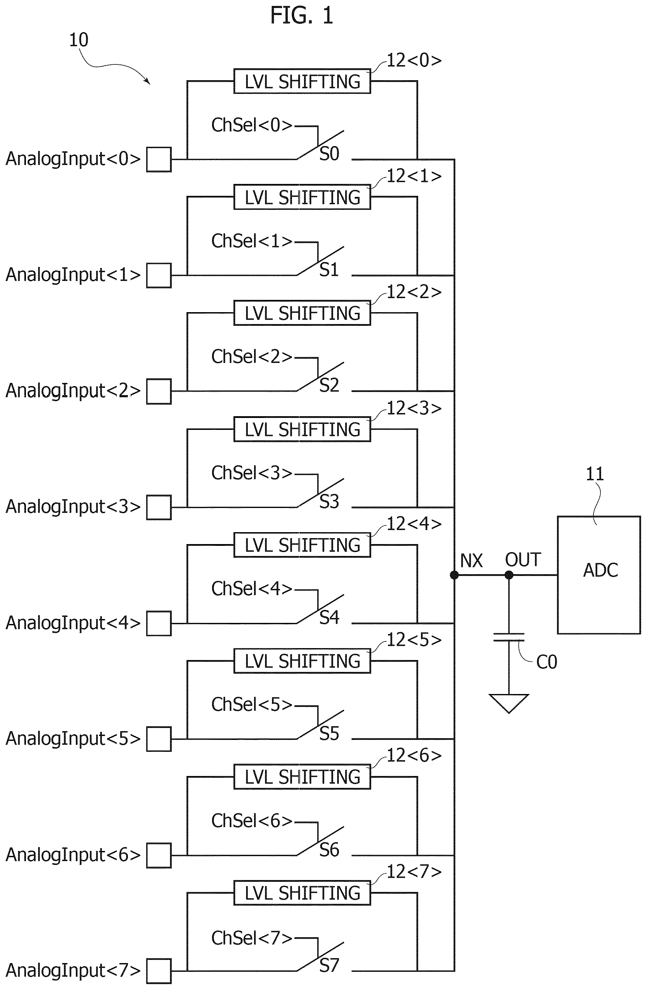

Shown in FIG. 1 is a circuit diagram for an eight channel multiplexer 10 that receives eight analog inputs at its eight analog input nodes AnalogInput<0>-AnalogInput<7>. Eight channel selection switches S0-S7 are respectively connected between the analog input nodes AnalogInput<0>-AnalogInput<7> and node NX, and are respectively controlled by eight channel selection signals ChSel<0>-ChSel<7>. Under control of the channel selection signals ChSel<0>-ChSel<7>, the channel selection switches S0-S7 selectively connect a selected one of the analog input nodes AnalogInput<0>-AnalogInput<7> at a time to node NX, which in turn is connected to the input of the analog to digital converter (ADC) 11 at node OUT, in accordance with a timing that will be described below, so that the ADC 11 digitizes the signal at the selected analog input node AnalogInput<0>-AnalogInput<7>. Level shifting circuits 12<0>-12<7> are respectively connected in parallel with the channel selection switches S0-S7 between the analog input nodes AnalogInput<0>-AnalogInput<7> and the node NX. The level shifting circuits 12<0>-12<7>, as will be explained below, serve to charge or discharge the sampling capacitor CO at the input of the ADC 11 at node OUT to slightly below/above the voltage of the analog input node AnalogInput<0>-AnalogInput<7> of the selected channel prior to closing of the channel selection switch S0-S7 of the selected channel, so that the charge taken from the analog input node AnalogInput<0>-AnalogInput<7> of the selected channel to the sampling capacitor CO when the channel selection switch SO-S7 of the selected channel is closed is low in magnitude.

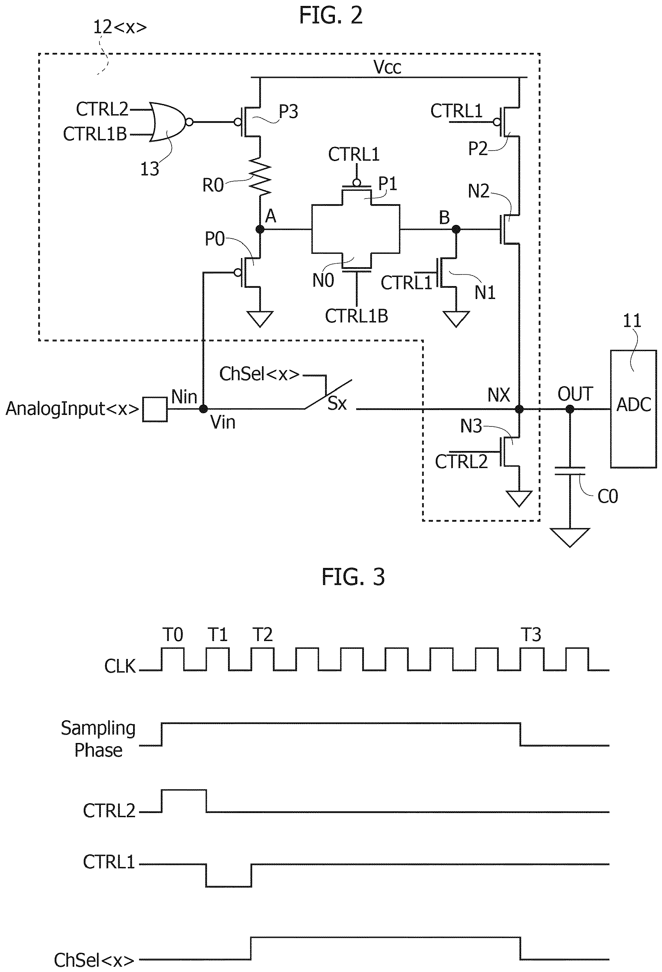

One possible variant of a level shifting circuit 12<x>, such as may be used as the level shifting circuits 12<0>-12<7> in the multiplexer 10 of FIG. 1, is now described with reference to FIG. 2. Here, an input voltage VIN is present at the input node Nin, which is connected to the analog input node AnalogInput<x>. The level shifting circuit 12<x> includes an n-channel transistor N3 having its drain connected to node NX, its source connected to ground, and its gate connected to control signal CTRL2. The sampling capacitor CO is connected between the output node OUT and ground, and the output node OUT is connected to the node NX. A p-channel transistor P0 has its source connected to node A, its drain connected to ground, and its gate connected to the input node Nin. A p-channel transistor P3 has its source connected to the supply voltage VCC, its drain connected to the source of the p-channel transistor P0 through resistor R0, and its gate connected to the output of NOR gate 13. NOR gate 13 receives as input the control signal CTRL2 and the complement of the control signal CTRL1 (represented as CTRL1B for shorthand), and provides its output to the gate of p-channel transistor P3.

An n-channel transistor N1 has its drain connected to node B, its source connected to ground, and its gate connected to the control signal CTRL1. An n-channel transistor N2 has its drain connected to the drain of p-channel transistor P2, its source connected to node NX, and its gate connected to node B. The p-channel transistor P2 has its source connected to the supply voltage VCC, its drain connected to the drain of the n-channel transistor N2, and its gate connected to the control signal CTRL1.

A transmission gate formed by p-channel transistor P1 and n-channel transistor N0 is connected between nodes A and B. In particular, the p-channel transistor P1 has its source connected to node A, its drain connected to node B, and its gate connected to the control signal CTRL1, while the n-channel transistor N0 has its drain connected to node A, its source connected to node B, and its gate connected to the complement of the first control signal CTRL1B.

Operation of the level shifting circuit 12<x> is now described with additional reference to FIG. 3. The below description is for the case where the channel associated with the level shifting circuit 12<x> is selected; each other channel is deselected (meaning that the CTRL1 signals of the deselected channels remain high while the CTRL2 signals of the deselected channels remain low). Therefore, for the selected channel to which the level shifting circuit 12<x> is associated, at time T0, in response to the rising edge of the first clock CLK pulse, a sampling phase of the ADC 11 begins with the control signal CTRL2 rising to a logic high, while the control signal CTRL1 remains at a logic high. Note that ChSel<x> remains at a logic low.

As a result of CTRL2 being high, n-channel transistor N3 turns on, discharging the sampling capacitor CO. As a result of CTRL1 being high, the transmission gate formed by p-channel transistor P1 and n-channel transistor N0 is turned off, the p-channel transistor P2 is turned off, and the n-channel transistor N1 turns on to sink current from node B to maintain n-channel transistor N2 in an off state.

As a result of CTRL2 being high and CTRL1B being low (because CTRL1 is high), the output of the NOR gate 13 is a logic low, turning on p-channel transistor P3. Since the p-channel transistor P0 in combination with the resistor RO forms a source follower amplifier, the voltage at node A will rise to the voltage at AnalogInput<x> plus the magnitude of the threshold voltage Vth of the p-channel transistor P0. The voltage at node A can therefore be mathematically represented as:

$$Va = VIN + |Th_{P0}|$$

At time T1, the control signals CTRL2 and CTRL1 fall low, and again note that ChSel<x> remains low. This turns on p-channel transistor P1 and n-channel transistor N0, and since this also turns off the n-channel transistor N1, this allows the voltage at node B to equal the voltage at node A. The voltage at node B can therefore be mathematically represented as:

$$Vb = Va = VIN + |Th_{P0}|$$

Since CTRL1 being low turns on p-channel transistor P2, and since the n-channel transistor N2 is a source follower, the n-channel transistor N2 sources current to the output node NX to charge the sampling capacitor C0 until the voltage at the output node OUT becomes equal to the voltage at node B less the threshold voltage of the n-channel transistor N2. Mathematically, the voltage at the output node OUT becomes equal to:

$$VOUT = Vb - Th_{N2} = VIN + |Th_{P0}| - Th_{N2}$$

Due the process variation and the fact that transistors P0 and N2 are not ideal, this means that the threshold voltages of P0 and N2 are not equal. In the case that the threshold voltage of N2 is greater than the magnitude of the threshold voltage of P0, VOUT will be less than VIN. In the opposite case, VOUT can be slightly higher than VIN. The above equations remain accurate unless VIN is one threshold lower than the supply voltage VCC.

At time T2, CTRL2 remains low, while CTRL1 rises high. Note that at this point, ChSel<x> rises high closing the switch Sx to select the channel associated with the level shifting circuit 12<x>, while the corresponding ChSel signals of each level shifting circuit 12 of each other channel remains low to keep their respective switches Sx off. Switch Sx closing will cause current to flow from the analog input node AnalogInput<x> to the sampling capacitor C0 to charge the sampling capacitor C0 to VIN. However, since the sampling capacitor C0 will be charged to nearly VIN between times T1 and T2 (VIN less/more the difference between the magnitude of the threshold voltage of P0 and the threshold voltage of N2), the current flowing from the analog input node AnalogInput<x> to the output node OUT will be low, being much lower in magnitude than the current typically flowing from the analog input node to the output node in prior art designs.

The sampling phase ends at time T3.

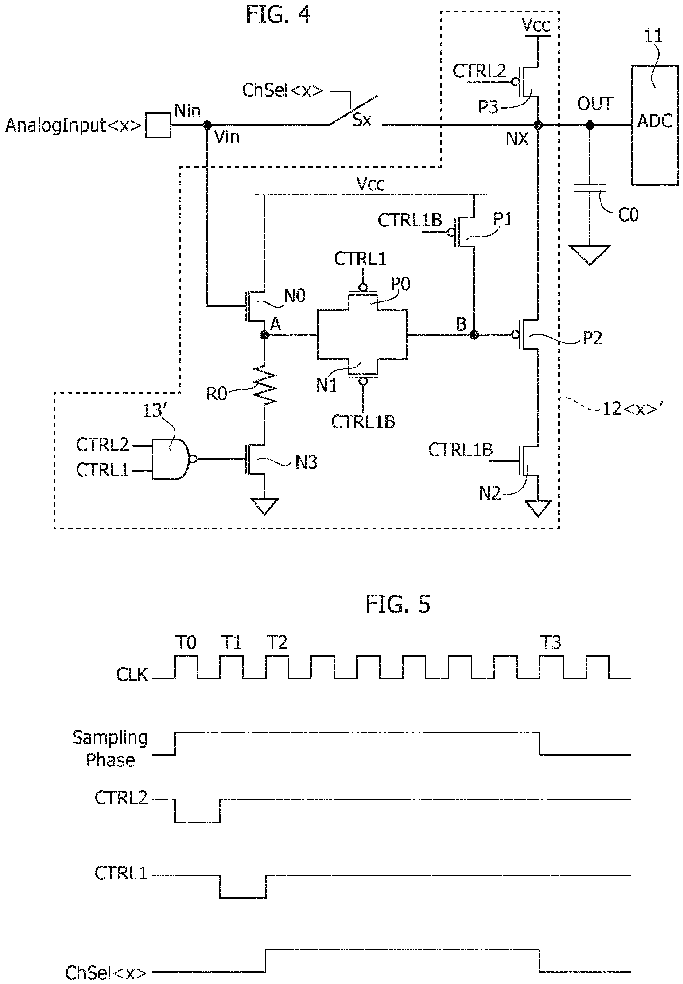

A variant 12<x>' is shown in FIG. 4. The primary difference here is that the sampling capacitor CO is charged to the supply voltage VCC and then discharged to remain in the proximity of VIN prior to switch Sx closing.

Details are now given. Here, p-channel transistor P3 has its source connected to the supply voltage VCC, its drain connected to the node NX, and its gate connected to the control signal CTRL2. In addition, the sampling capacitor CO is connected between the output node OUT and ground. The node NX is connected to the output node OUT. The n-channel transistor N0 has its drain connected to VCC, its source connected to node A, and its gate connected to the input node Nin. N-channel transistor N3 has its drain connected to node A through the resistor R0, its source connected to ground, and its gate connected to the output of the NAND gate 13'. The NAND gate 13' receives the control signals CTRL1 and CTRL2 as input and provides its output to the gate of the n-channel transistor N3.

P-channel transistor P1 has its source connected to VCC, its drain connected to node B, and its gate connected to the complement of the first control signal CTRL1B. P-channel transistor P2 has its source connected to the node NX, its drain connected to the drain of n-channel transistor N2, and its gate connected to node B. N-channel transistor N2 has its drain connected to the drain of p-channel transistor P1, its source connected to ground, and its gate connected to the complement of the first control signal CTRL1B.

A transmission gate is formed by p-channel transistor P0 and n-channel transistor N1. In particular, p-channel transistor P0 has its source connected to node B, its drain connected to node A, and its gate connected to the control signal CTRL1, while n-channel transistor N1 has its drain connected to node B, its source connected to node A, and its gate connected to the complement of the first control signal CTRL1B.

Operation of the level shifting circuit 12<x>' is now described with additional reference to FIG. 5. The below description is for the case where the channel associated with the level shifting circuit 12<x>' is selected; each other channel is deselected (meaning that the CTRL1 signals of the deselected channels remain high while the CTRL2 signals of the deselected channels remain low). Therefore, for the selected channel to which the level shifting circuit 12<x>' is associated. At time T0, in response to the rising edge of the first clock CLK pulse, a sampling phase of the ADC 11 begins with the control signal CTRL2 falling to a logic low, while the control signal CTRL1 remains at a logic high. Note that ChSel<x> remains at a logic low.

As a result of CTRL2 being low, p-channel transistor P3 turns on, charging the sampling capacitor CO to the supply voltage VCC. As a result of CTRL1 being high, the transmission gate formed by p-channel transistor P0 and n-channel transistor N1 is turned off, the n-channel transistor N2 is turned off, and the p-channel transistor P1 turns on to source current to node B to maintain p-channel transistor P2 in an off state.

As a result of CTRL2 being low and CTRL1 being high, the output of the NAND gate 13' is a logic high, turning on n-channel transistor N3. Since the n-channel transistor N0 in combination with the resistor RO forms a source follower amplifier, the voltage at node A will rise to the voltage at AnalogInput<x> less the magnitude of the threshold voltage Vth of the n-channel transistor N0. The voltage at node A can therefore be mathematically represented as:

$$Va=VIN-Th_{N0}$$

At time T1, the control signal CTRL1 falls low while the control signal CTRL2 rises high, and again note that ChSel<x> remains low. This turns on p-channel transistor P0 and n-channel transistor N1, and since this also turns off the p-channel transistor P1, this allows the voltage at node B to become equal the voltage at node A. The voltage at node B can therefore be mathematically represented as:

$$Vb=Va=VIN-Th_{N0}$$

Since CTRL1 being low turns on n-channel transistor N2, and since the p-channel transistor P2 is a source follower, the p-channel transistor P2 sinks current from the node NX to discharge the sampling capacitor C0 until the voltage at the output node OUT becomes equal to the voltage at node B plus the magnitude of the threshold voltage of the p-channel transistor P2. Mathematically therefore, the voltage at the output node OUT becomes equal to:

$$VOUT=Vb+Th_{P2}=VIN+|Th_{P2}|-Th_{N0}$$

Due the process variation and the fact that transistors P2 and N0 are not ideal, this means that the threshold voltages of P2 and N0 are not equal. In the case that the threshold voltage of N0 is greater than the magnitude of the threshold voltage of P2, VOUT will be less than VIN. In the opposite case, VOUT can be slightly higher than VIN.

At time T2, CTRL2 remains high, while CTR1 rises high. Note that at this point, ChSel<x> rises high closing the switch Sx to select the channel associated with the level shifting circuit 12<x>', while the corresponding ChSel signals of each level shifting circuit 12 of each other channel remains low to keep their respective switches Sx off. Switch Sx closing will cause current to flow from the analog input node AnalogInput<x> to the sampling capacitor C0 to charge the sampling capacitor C0 to VIN. However, since the sampling capacitor C0 will be charged to nearly VIN between times T1 and T2, the current flowing from the analog input node AnalogInput<x> to the output node OUT will be low, being much lower in magnitude than the current typically flowing from the analog input node to the output node in prior art designs.

The sampling phase ends at time T3. In both above embodiments, process trimming option can be used to remove the mismatch between PMOS and NMOS threshold voltages to keep the charge from the analog input nodes to the minimum. As an example, the trimming of resistor R0 can achieve this.

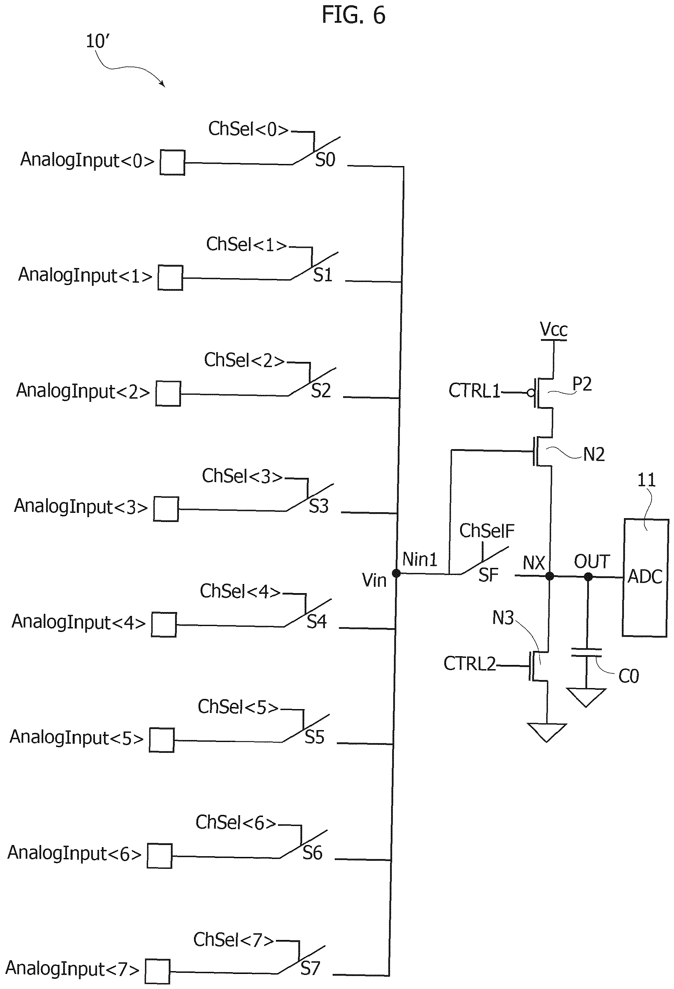

Another design not in accordance with the invention as claimed for a multiplexer 10' that results in less current sourced to the sampling capacitor C0 than prior art designs is shown in FIG. 6. Here, the multiplexer 10' is an eight channel multiplexer 10' that receives eight analog inputs at its eight analog input nodes AnalogInput<0>-AnalogInput<7>. Eight channel selection switches S0-S7 are respectively connected between the analog input nodes AnalogInput<0>-AnalogInput<7> and node Nin1, and are respectively controlled by eight channel selection signals ChSel<0>-ChSel<7>. Under control of the channel selection signals ChSel<0>-ChSel<7>, the channel selection switches S0-S7 selectively connect a selected one of the analog input nodes AnalogInput<0>-AnalogInput<7> at a time to the node Nin1, in accordance with a timing as will be described below.

Here, a final selection switch SF is connected between node Nin1 and node NX (node NX in turn being connected to the output node OUT), and operates under control of the final channel selection signal ChSelF. An n-channel transistor N3 has its drain connected to the node NX, its source connected to ground, and its gate connected to the control signal CTRL2. A p-channel transistor P2 has its source connected to the supply voltage VCC, its drain connected to the drain of n-channel transistor N2, and its gate connected to the control signal CTRL1. The n-channel transistor N2 has its drain connected to the drain of the p-channel transistor P2, its source connected to the node NX, and its gate connected to the node Nin1.

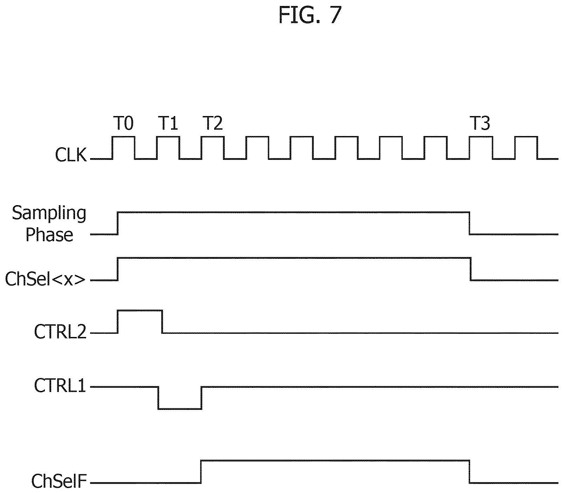

Operation of the multiplexer 10' is now described with additional reference to FIG. 7.

At time T0, in response to the rising edge of the first clock CLK pulse, a sampling phase of the ADC 11 begins with the control signal CTRL2 rising to a logic high, while the control signal CTRL1 remains at a logic high. Note that ChSel<x> (with x corresponding to ChSel of the selected channel) rises to a logic high while ChSelF remains at a logic low. ChSel for every non-selected channel remains low.

In response to ChSel<x> rising to a logic high, the corresponding switch S closes, charging node Nin1 to Vin. Since the control signal CTRL1 remains at a logic high, the p-channel transistor P2 remains off, permitting the discharge of the sampling capacitor C0. Since the control signal CTRL2 is at a logic high, the n-channel transistor N3 will turn on, discharging the sampling capacitor C0 between time periods T0 and T1.

At time T1, in response to the rising of the second clock CLK pulse, the control signals CTRL1 and CTRL2 both fall to a logic low. Note that ChSel<x> remains at a logic high while ChSelF remains at a logic low. Since CTRL2 is a logic low, n-channel transistor N3 turns off, and since CTRL1 is low, p-channel transistor P2 turns on. The result of this is that the n-channel transistor N2 sources sufficient current to the sampling capacitor C0 between times T1 and T2 to charge the sampling capacitor C0 nearly to VIN (VIN less the threshold voltage of the n-channel transistor N2). Mathematically, this can be represented as:

$$VOUT=VIN-Th_{N2}$$

At time T2, in response to the rising of the third clock CLK pulse, the control signal CTRL1 rises to a logic high while the control signal CTRL2 remains at a logic low. Note that ChSelF here rises to a logic high while ChSel<x> remains at a logic high. Since the switch SF is closed in response to ChSelF going high, the selected analog input AnalogInput will source sufficient current to the output node OUT to charge VOUT to be equal to VIN. The current flowing from the analog input AnalogInput to the output node OUT will be low, being much lower in magnitude than the current typically flowing from the analog input node to the output node in prior art designs.

At time T3, the sampling phase of the ADC 11 ends. This is an area efficient logic as only this small logic will be needed for the complete multiplexer 10', with the addition of switch SF. Here the analog input AnalogInput always provides a charge corresponding to the threshold voltage of N2.

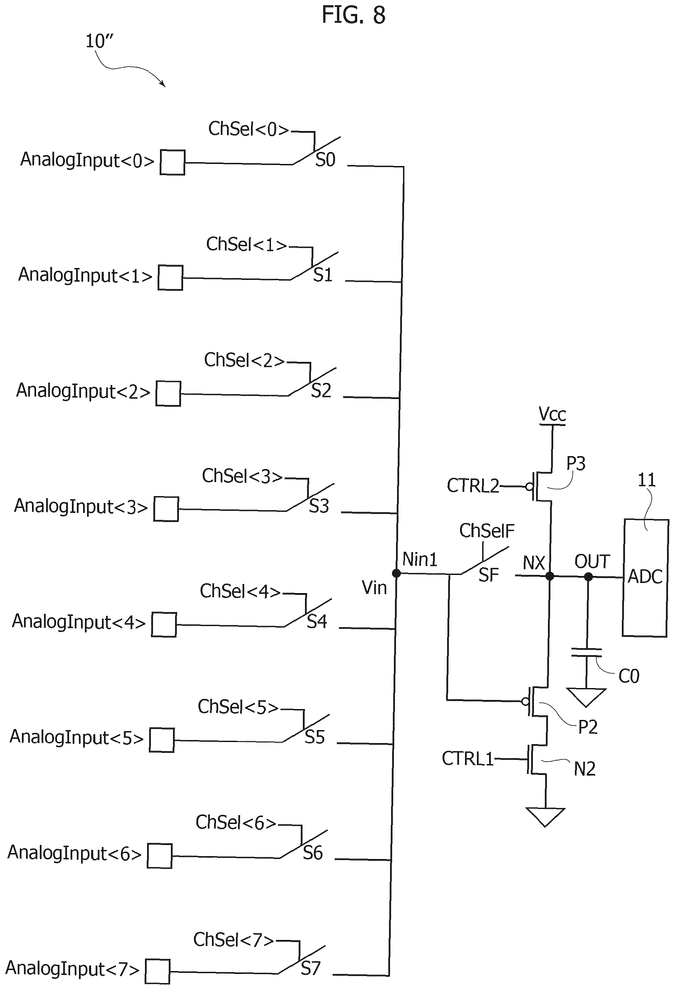

A variant of the multiplexer 10" not in accordance with the invention as claimed is now described with reference to FIG. 8. The multiplexer 10" is an eight channel multiplexer 10 that receives eight analog inputs at its eight analog input nodes AnalogInput<0>-AnalogInput<7>. Eight channel selection switches S0-S7 are respectively connected between the analog input nodes AnalogInput<0>-AnalogInput<7> and node Nin1, and are respectively controlled by eight channel selection signals ChSel<0>-ChSel<7>. Under control of the channel selection signals ChSel<0>-ChSel<7>, the channel selection switches S0-S7 selectively connect a selected one of the analog input nodes AnalogInput<0>-AnalogInput<7> at a time to the node Nin1, in accordance with a timing as will be described below.

Here, a final selection switch SF is connected between node Nin1 and node NX (which in turn is connected to the output node OUT), and operates under control of the final channel selection signal ChSelF. A p-channel transistor P3 has its drain connected to the nodeNX, its source connected to the supply voltage VCC, and its gate connected to the control signal CTRL2. A p-channel transistor P2 has its source connected to the node NX, its drain connected to the drain of n-channel transistor N2, and its gate connected to node Nin1. The n-channel transistor N2 has its drain connected to the drain of the p-channel transistor P2, its source connected to ground, and its gate connected to the control signal CTRL1.

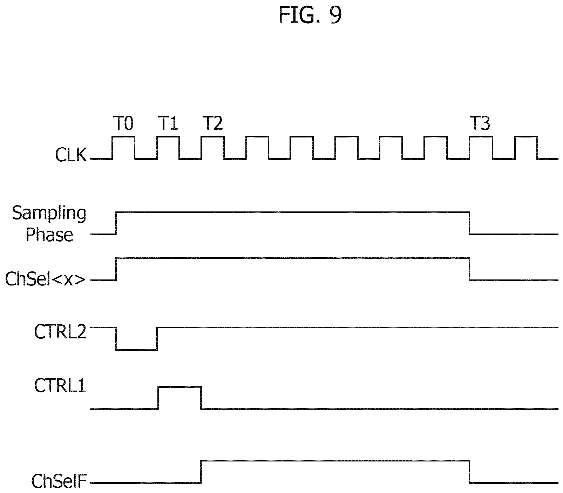

With additional reference to FIG. 9, operation of the multiplexer 10" is now described. At time T0, in response to the rising of the first clock CLK pulse, a sampling phase of the ADC 11 begins with the control signal CTRL2 falling to a logic low, while the control signal CTRL1 remains at a logic low. Note that ChSel<x> rises to a logic high while ChSelF remains at a logic low.

In response to ChSel<x> (which corresponds to ChSel of one of the channels of the multiplexer 10") rising to a logic high, the corresponding switch Sx closes, charging node Nin1 to VIN. Since the control signal CTRL1 remains at a logic low, the n-channel transistor N2 remains off, permitting the charging of the sampling capacitor CO. Since the control signal CTRL2 is at a logic low, the p-channel transistor P3 will turn on, charging the sampling capacitor CO to VCC between time periods T0 and T1.

At time T1, in response to the rising of the second clock CLK pulse, the control signals CTRL1 and CTRL2 rise to a logic high. Note that ChSel<x> remains at a logic high while ChSelF remains at a logic low. Since CTRL2 is a logic high, p-channel transistor P3 turns off, and since CTRL1 is also at a logic high, n-channel transistor N2 turns on. The result of this is that the p-channel transistor P2 sinks sufficient current from the sampling capacitor C0 between times T1 and T2 to discharge the sampling capacitor nearly to VIN (VIN plus the magnitude of the threshold voltage of the p-channel transistor P2). Mathematically, this can be represented as:

$$VOUT=VIN+|Th_{P2}|$$

At time T2, in response to the rising of the third clock CLK pulse, the control signal CTRL1 falls to a logic low while the control signal CTRL2 remains at a logic high. Note that ChSelF here rises to a logic high while ChSel<x> remains at a logic high. Since the switch SF is closed in response to ChSelF going high, the selected analog input AnalogInput will sink sufficient current from the output node OUT to discharge VOUT to be equal to VIN. The current flowing to the analog input AnalogInput from the output node OUT will be low, being much lower in magnitude than the current typically flowing from the output node to the analog input node in prior art designs.

At time T3, the sampling phase of the ADC 11 ends. This is a very area efficient logic as only this small logic will be needed for the complete multiplexer 10", with the addition of switch SF. Here the analog input node AnalogInput sinks a charge corresponding to the threshold voltage of P2.

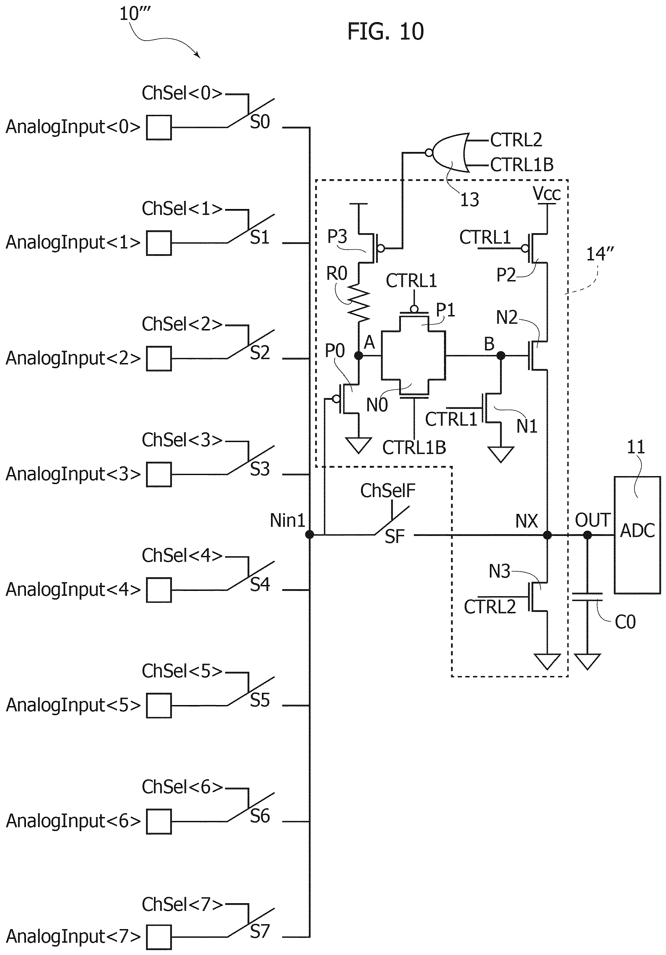

Another variant of multiplexer 10"' not in accordance with the invention as claimed is shown in FIG. 10. The multiplexer 10"' is an eight channel multiplexer 10 that receives eight analog inputs at its eight analog input nodes AnalogInput<0>-AnalogInput<7>. Eight channel selection switches S0-S7 are respectively connected between the analog input nodes AnalogInput<0>-AnalogInput<7> and node Nin1, and are respectively controlled by eight channel selection signals ChSel<0>-ChSel<7>. Under control of the channel selection signals ChSel<0>-ChSel<7>, the channel selection switches S0-S7 selectively connect a selected one of the analog input nodes AnalogInput<0>-AnalogInput<7> at a time to the node Nin1, in accordance with a timing as will be described below.

Here, a final selection switch SF is connected between node Nin1 and node NX (which in turn is connected to the output node OUT), and operates under control of the final channel selection signal ChSelF.

The multiplexer 10''' includes an n-channel transistor N3 having its drain connected to the node NX, its source connected to ground, and its gate connected to control signal CTRL2. A p-channel transistor P0 has its source connected to node A, its drain connected to ground, and its gate connected to node Nin1. A p-channel transistor P3 has its source connected to the supply voltage VCC, its drain connected to the source of the p-channel transistor P0 through resistor R0, and its gate connected to the output of NOR gate 13. NOR gate 13 receives as input the control signal CTRL2 and the complement of the control signal CTRL1 (represented as CTRL1B for shorthand), and provides its output to the gate of p-channel transistor P3.

An n-channel transistor N1 has its drain connected to node B, its source connected to ground, and its gate connected to the control signal CTRL1. An n-channel transistor N2 has its drain connected to the drain of p-channel transistor P2, its source connected to the node NX, and its gate connected to node B. The p-channel transistor P2 has its source connected to the supply voltage VCC, its drain connected to the drain of the n-channel transistor N2, and its gate connected to the control signal CTRL1.

A transmission gate formed by p-channel transistor P1 and n-channel transistor N0 is connected between nodes A and B. In particular, the p-channel transistor P1 has its source connected to node A, its drain connected to node B, and its gate connected to the control signal CTRL1, while the n-channel transistor N0 has its drain connected to node A, its source connected to node B, and its gate connected to the complement of the first control signal CTRL1B.

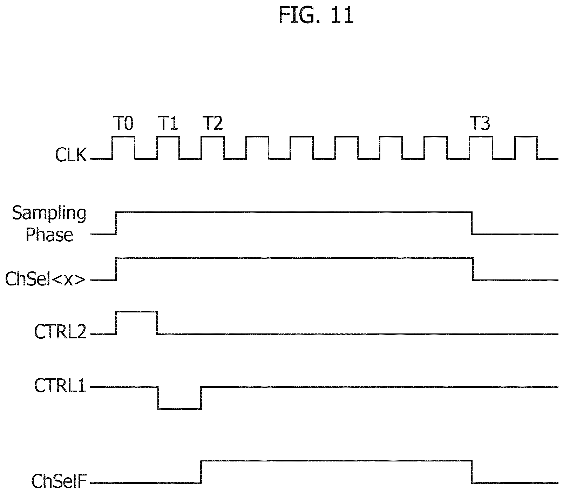

Operation of the multiplexer 10''' is now described with additional reference to FIG. 11. At time T0, in response to the rising of the first clock CLK pulse, a sampling phase of the ADC 11 begins with the control signal CTRL2 rising to a logic high, while the control signal CTRL1 remains at a logic high. Note that ChSel<x> rises to a logic high while ChSelF remains at a logic low

As a result of CTRL2 being high, n-channel transistor N3 turns on, discharging the sampling capacitor CO. As a result of CTRL1 being high, the transmission gate formed by p-channel transistor P1 and n-channel transistor N0 is turned off, the p-channel transistor P2 is turned off, and the n-channel transistor N1 turns on to sink current from node B to maintain n-channel transistor N2 in an off state.

As a result of CTRL2 being high and CTRL1B being low (because CTRL1 is high), the output of the NOR gate 13 is a logic low, turning on p-channel transistor P3. Since the p-channel transistor P0 in combination with the resistor RO forms a source follower amplifier, the voltage at node A will rise to VIN plus the magnitude of the threshold voltage Vth of the p-channel transistor P0. The voltage at node A can therefore be mathematically represented as:

$$Va = VIN + |Th_{P0}|$$

At time T1, the control signals CTRL2 and CTRL1 fall low, and again note that ChSel<x> remains high. This turns on p-channel transistor P1 and n-channel transistor N0, and since this also turns off the n-channel transistor N1, this allows the voltage at node B to equal the voltage at node A. The voltage at node B can therefore be mathematically represented as:

$$Vb = Va = VIN + |Th_{P0}|$$

Since CTRL1 being low turns on p-channel transistor P2, and since the n-channel transistor N2 is a source follower, the n-channel transistor N2 sources current to the output node N2 to charge the sampling capacitor CO until the voltage at the output node OUT becomes equal to the voltage at node B less the threshold voltage of the n-channel transistor N2. Mathematically therefore, the voltage at the output node OUT becomes equal to:

$$VOUT = Vb - Th_{N2} = VIN + |Th_{P0}| - Th_{N2}$$

Due the process variation and the fact that transistors P0 and N2 are not ideal, this means that the threshold voltages of P0 and N2 are not equal. In the case that the threshold voltage of N2 is greater than the magnitude of the threshold voltage of P0, VOUT will be less than VIN. In the opposite case, VOUT can be slightly higher than VIN.

At time T2, CTRL2 remains low, while CTRL1 rises high. Note that at this point, ChSelF rises high, closing the switch SF. Switch SF closing will cause current to flow from the node Nin1 to the sampling capacitor C0 to charge the sampling capacitor C0 to VIN. However, since the sampling capacitor C0 will be charged to nearly VIN between times T1 and T2 (VIN less the difference between the magnitude of the threshold voltage of P0 and the threshold voltage of N2), the current flowing from the node Nin1 to the output node OUT will be low, being much lower in magnitude than the current typically flowing to the output node in prior art designs.

The sampling phase ends at time T3. This is an improvement over the design of FIG. 6 as this removes the requirement of an input charge from the analog input node corresponding to threshold voltage of N2. In additional, only this single circuit will be needed for complete multiplexer, so this is a very area efficient design.

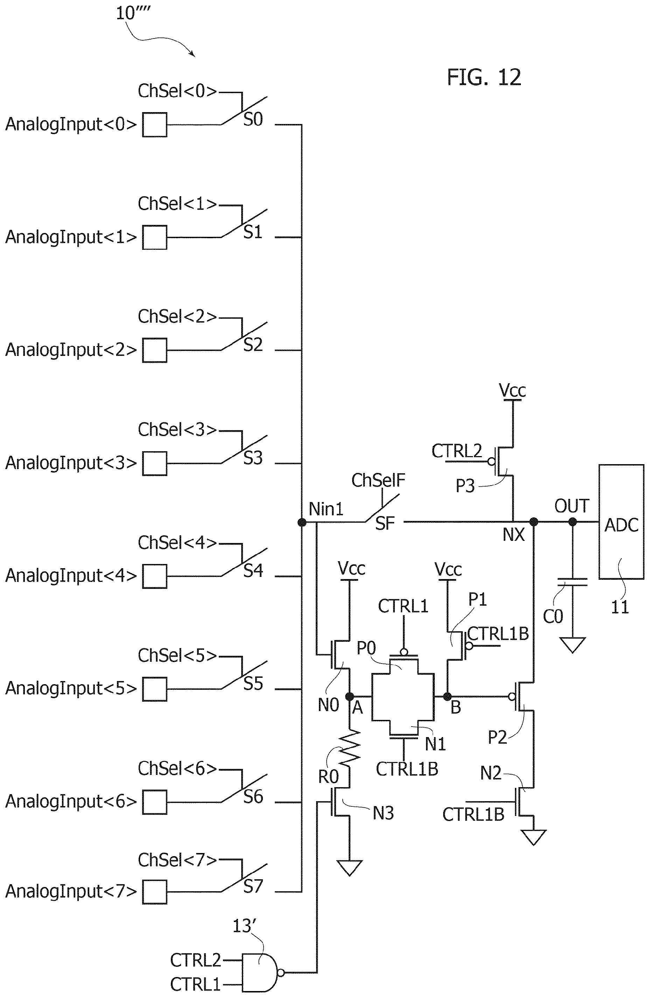

A variant of the multiplexer 10'''' not in accordance with the invention as claimed is shown in FIG. 12. Here, p-channel transistor P3 has its source connected to the supply voltage VCC, its drain connected to the node NX (which in turn is connected to the output node OUT), and its gate connected to the control signal CTRL2. In addition, n-channel transistor N0 has its drain connected to VCC, its source connected to node A, and its gate connected to node Nin1. N-channel transistor N3 has its drain connected to node A through the resistor R0, its source connected to ground, and its gate connected to the output of the NAND gate 13'. The NAND gate 13' receives the control signals CTRL1 and CTRL2 as input and provides its output to the gate of the n-channel transistor N3.

P-channel transistor P1 has its source connected to VCC, its drain connected to node B, and its gate connected to the complement of the first control signal CTRL1B. P-channel transistor P2 has its source connected to the node NX, its drain connected to the drain of n-channel transistor N2, and its gate connected to node B. N-channel transistor N2 has its drain connected to the drain of p-channel transistor P1, its source connected to ground, and its gate connected to the complement of the first control signal CTRL1B.

A transmission gate is formed by p-channel transistor P0 and n-channel transistor N1. In particular, p-channel transistor P0 has its source connected to node B, its drain connected to node A, and its gate connected to the control signal CTRL1, while n-channel transistor N1 has its drain connected to node B, its source connected to node A, and its gate connected to the complement of the first control signal CTRL1B.

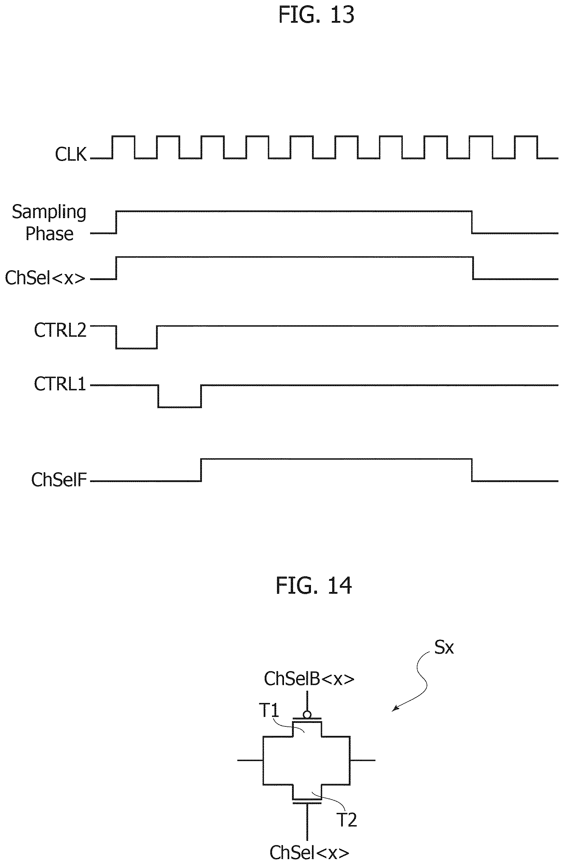

Operation of the multiplexer 10'''' is now described with additional reference to FIG. 13. At time T0, in response to the rising of the first clock CLK pulse, a sampling phase of the ADC 11 begins with the control signal CTRL2 falling to a logic low, while the control signal CTRL1 remains at a logic high. Note that ChSel<x> rises to a logic high while ChSelF remains at a logic low.

As a result of CTRL2 being low, p-channel transistor P3 turns on, charging the sampling capacitor CO to the supply voltage VCC. As a result of CTRL1 being high, the transmission gate formed by p-channel transistor P0 and n-channel transistor N1 is turned off, the n-channel transistor N2 is turned off, and the p-channel transistor P1 turns on to source current to node B to maintain p-channel transistor P2 in an off state.

As a result of CTRL2 being low and CTRL1 being high, the output of the NAND gate 13' is a logic high, turning on n-channel transistor N3. Since the n-channel transistor N0 in combination with the resistor RO forms a source follower, the voltage at node A will rise to the voltage at AnalogInput<x> less the magnitude of the threshold voltage Vth of the n-channel transistor N0. The voltage at node A can therefore be mathematically represented as:

$$Va = VIN - Th_{N0}$$

At time T1, the control signal CTRL1 falls low while the control signal CTRL2 rises high, and again note that ChSel<x> remains high while ChSelF remains low. This turns on p-channel transistor P0 and n-channel transistor N1, and since this also turns off the p-channel transistor P1, this allows the voltage at node B to equal the voltage at node A. The voltage at node B can therefore be mathematically represented as:

$$Vb = Va = VIN - Th_{N0}$$

Since CTRL1 being low turns on n-channel transistor N2, and since the p-channel transistor P2 is a source follower, the p-channel transistor P2 sinks current from the output node OUT to discharge the sampling capacitor CO until the voltage at the output node OUT becomes equal to the voltage at node B plus the magnitude of the threshold voltage of the p-channel transistor P2. Mathematically therefore, the voltage at the output node OUT becomes equal to:

$$VOUT = Vb + Th_{P2} = VIN + |Th_{P2}| - Th_{N0}$$

Due the process variation and the fact that transistors P2 and N0 are not ideal, this means that the threshold voltages of P2 and N0 are not equal. In the case that the threshold voltage of N0 is greater than the magnitude of the threshold voltage of P2, VOUT will be less than VIN. In the opposite case, VOUT can be slightly higher than VIN.

At time T2, CTRL2 remains high, while CTR1 rises high. Note that at this point, ChSel<x> remains high and ChSelF rises high, closing the switch Sx. Switch Sx closing will cause current to flow from node Nin1 to the sampling capacitor CO to charge the sampling capacitor CO to VIN. However, since the sampling capacitor CO will be charged to nearly VIN between times T1 and T2, the current flowing from the node NX to the output node OUT will be low, being much lower in magnitude than the current typically flowing to the output node in prior art designs.

The sampling phase ends at time T3.

As shown in FIG. 14, the switches S0-S7 of any discussed embodiment may be implemented as a transmission gate comprised of p-channel transistor T1 and n-channel transistor T2.

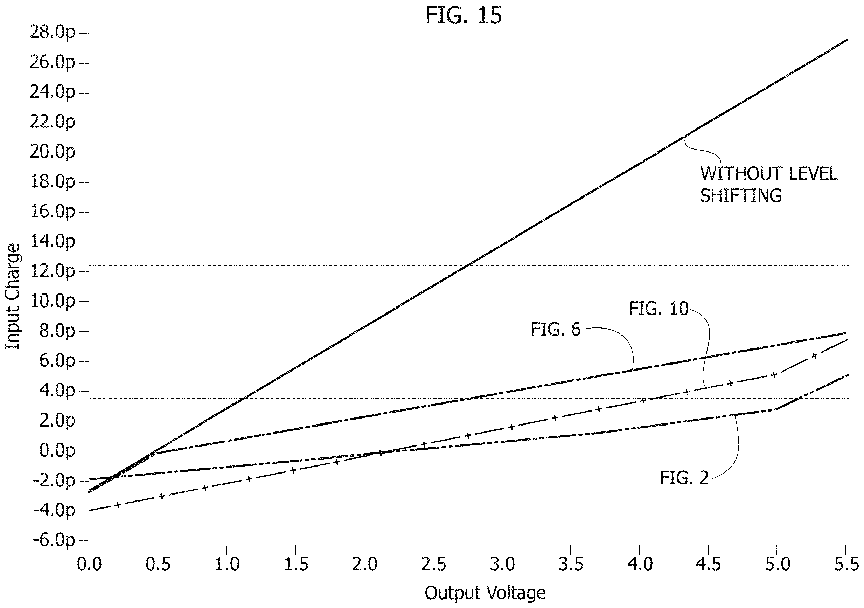

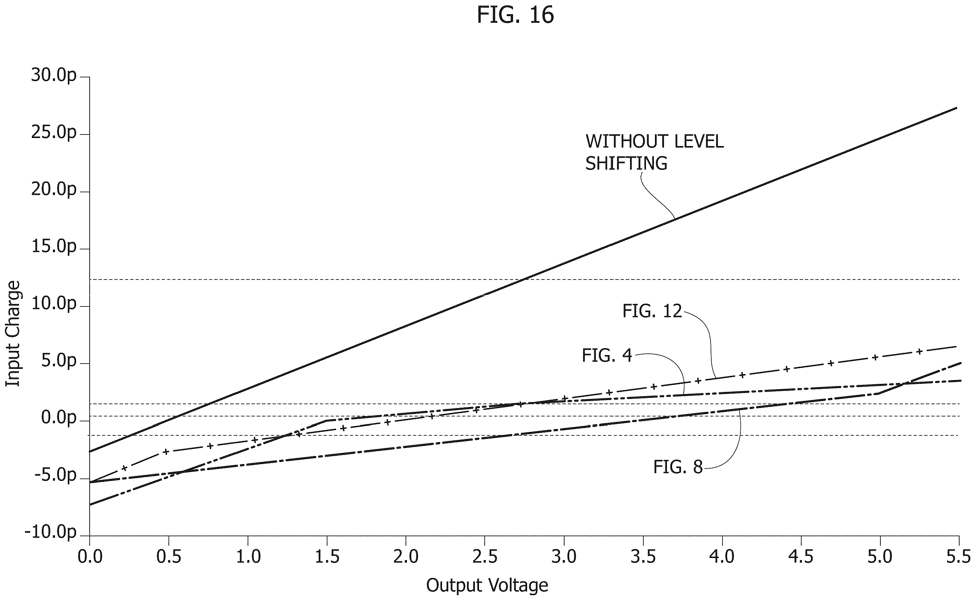

The usage of the various designs described above drastically lowers the magnitude of the current conducted from the analog input node of the selected channel to the sampling capacitor. Shown in FIGS 15-16 are graphs showing the magnitude of the charge taken from the analog input node of the selected channel to the sampling capacitor, for different input voltages, and for the various designs. For example, as can be seen in FIG. 15, at an input voltage of 2.5 volts, without the above described designs, the magnitude of the charge from the analog input node would be 12.4 pC, but with the designs of FIGS. 2, 6, and 10, the magnitude of the charge from the analog input node is instead 553.6 fC, 3.43 pC, and 975.6 fC, respectively. As another example, as can be seen in FIG. 16, at an input voltage of 2.5 V, without the above described designs, the magnitude of the charge from the analog input node would be 12.4 pC, but with the designs of FIGS. 4, 8, and 12, the magnitude of the charge from the analog input node would be 370.7 fC, 1.109 pC, and 1.5 pC, respectively.

As exemplified herein (see, for instance, Figures 2 and 4), an input circuit for a multiplexer (for instance, 10) comprises:

a first analog input node (for instance, Nin);
an output node (for instance, OUT);
a capacitive node (for instance, C0) connected to the output node (for instance, OUT);
a first control circuit (for instance, N3, P3) configured to set a charge at the capacitive node to a desired voltage during a first period of time (for instance, T0-T1) beginning in response to a start of a sampling cycle of an analog to digital converter (for instance, 11) where input to the analog to digital converter is driven by output from the multiplexer;
a second control circuit (for instance, N1, P1, N0, P2, 13, R0, P3; P1, P0, N1, N2, 13', R0, N3) configured to set a charge at the capacitive node to a voltage at the first analog input node, modified by a mismatch voltage resulting from mismatch in threshold voltages between a first transistor (for instance, P0, N0) connected to the first analog input node and a second transistor (for instance, N2, P2) connected to the output node, during a second period of time (for instance, T1-T2) beginning in response to expiration of the first period of time; and
a first channel selection switch (for instance, Sx) that closes to connect the first analog input node to the output node to thereby charge the capacitive node to the voltage at the first analog input node, the first channel selection switch being closed in response to expiration of the second period of time;
wherein the first channel selection switch opens to disconnect the first analog input node, from the output node at an end of the sampling cycle of the analog to digital converter (11).

In an input circuit as exemplified herein (see, for instance, Figure 2),

the first control circuit comprises discharge circuitry (for instance, N3) configured to discharge the capacitive node (for instance, C0) to ground during the first period of time (for instance, T0-T1);
the second control circuit comprises level shifting circuitry (for instance, N1, P1, N0, P2, 13, R0, P3) configured to charge the capacitive node to the voltage at the first analog input node, modified by the mismatch voltage resulting from the mismatch in threshold voltages between the first transistor (for instance, P0) and the second transistor (for instance, N2), during the second period of time (for instance, T1-T2); and
the level shifting circuitry includes the first transistor (for instance, P0) and the second transistor (for instance, N2).

An input circuit as exemplified herein (see, for instance, Figure 2 and Figure 3) further comprises a control signal generator configured to:

assert a second control signal (for instance, CTRL2), for the first period of time (for instance, T0-T1), in response to the start of the sampling cycle of the analog to digital converter (for instance, 11);
deassert the second control signal in response to the expiration of the first period of time;
assert a first control signal (for instance, CTRL1), for the second period of time (for instance, T1-T2), in response to the expiration of the first period of time; and
deassert the first control signal in response to the expiration of the second period of time.

In an input circuit as exemplified herein (see again, for instance, Figure 2):

the first transistor comprises a first p-channel transistor (for instance, P0) having a drain connected to ground, a source connected to a first node (for instance, A), and a gate connected to the first analog input node (for instance, Nin);
the second transistor comprises a second n-channel transistor (for instance, N2) having a source connected to the output node (for instance, OUT) and a gate connected to a second node (for instance, B); and
the level shifting circuitry further comprises:

a first n-channel transistor (for instance, N1) having a drain connected to the second node, a source connected to ground, and a gate connected to the first control signal (for instance, CTRL1);
a transmission gate (for instance, P1, N0) configured to connect the first node to the second node in response to assertion of the first control signal;
a second p-channel transistor (for instance, P2) having a drain connected to a drain of the second n-channel transistor (for instance, N2), a source connected to a supply voltage (for instance, Vcc), and a gate connected to the first control signal;
a logic gate (for instance, 13) configured to generate a logic signal as a function of a logical operation performed on the second control signal (for instance, CTRL2) and a complement of the first control signal (for instance, CTRL1B),

a resistor (for instance, RO) having a first terminal connected to the first node (for instance, A); and

a third p-channel transistor (for instance, P3) having a drain connected to a second terminal of the resistor (for instance, RO), a source connected to the supply voltage (for instance, Vcc), and a gate connected to the logic signal (as produced by 13, for instance).

In an input circuit as exemplified herein (see Figure 2, for instance) the logic gate comprises a NOR gate (for instance, 13) receiving the second control signal (for instance, CTRL2) and a complement of the first control signal (for instance, CTRL1B) as input, and generating the logic signal as output.

In an input circuit as exemplified herein (see Figure 2, for instance), the discharge circuitry comprises a third n-channel transistor (for instance, N3) having a drain connected to the output node (for instance, OUT), a source connected to ground, and a gate connected to the second control signal (for instance, CTRL2).

In an input circuit as exemplified herein, while only one channel may be active at a time, more than one channel can have a level shifter as exemplified and the circuit may further comprise (see Figure 2, for instance):

a second analog input node (for instance, Nin);
second discharge circuitry (for instance, N3) configured to discharge the capacitive node (for instance, C0) during the first period of time (for instance, TO-T1);
second level shifting circuitry (for instance, P1, N1, P0, N2, 13, R0, N3) configured to charge the capacitive node to a voltage at the second analog input node, modified by a mismatch voltage resulting from mismatch in threshold voltages between a third transistor (for instance, P0) connected to the second analog input node and a fourth transistor (for instance, N2) connected to the output node (for instance, OUT), during the second period of time (for instance, T1-T2) ; and
a second channel selection switch (for instance, Sx) that closes to connect the second analog input node to the output node to thereby charge the capacitive node to the voltage at the second analog input node, the second channel selection switch being closed in response to expiration of the second period of time;
wherein the second channel selection switch opens to disconnect the second analog input node from the output node at the end (for instance, T3) of the sampling cycle of the analog to digital converter;
wherein the first channel selection switch operates based upon a first channel selection signal (for instance, ChSel<x>) that is asserted in response to expiration of the second period of time (for instance, T1-T2) and deasserted at the end (for instance, T3) of the sampling cycle of the analog to digital converter (for instance, 11) if a first channel including the first analog input node (for instance, Nin), discharge circuitry (for instance, N3), level shifting circuitry (for instance, N1, P1, N0, P2, 13, R0, P3) P3), and first channel selection switch is selected; and
wherein the second channel selection switch operates based upon a second channel selection signal (for instance, ChSel<x>) that is asserted in response to expiration of the second period of time and deasserted at the end of the sampling cycle of the analog to digital converter if a second channel including the second analog input node (for instance, Nin), second discharge circuitry (for instance, N3), second level shifting circuitry (for instance, P1, N1, P0, N2, 13, R0, N3), and second channel selection switch is selected.

In an input circuit as exemplified herein (see Figure 4, for instance):

the first control circuit comprises charge circuitry (for instance, P3) configured to charge the capacitive node (for instance, C0) to a supply voltage (for instance, Vcc), during the first period of time (for instance, TO-T1);
the second control circuit comprises level shifting circuitry (for instance, P1, N1, P0, N2, 13', R0, N3) configured to discharge the capacitive node to the voltage at the first analog input node (for instance, Nin), modified by the mismatch voltage resulting from the mismatch in threshold voltages between the first transistor (for instance, N0) and the second transistor (for instance, P2), during the second period of time (for instance, T1-T2); and
the level shifting circuitry includes the first transistor (for instance, N0) and the second transistor (for instance, P2).

An input circuit as exemplified herein (see Figures 4 and 5, for instance) comprises a control signal generator configured to:

assert a second control signal (for instance, CTRL2), for the first period of time (for instance, TO-T1), in response to the start of the sampling cycle of the analog to digital converter (for instance, 11);
deassert the second control signal in response to the expiration of the first period of time;
assert a first control signal (for instance, CTRL1), for the second period of time (for instance, T1-T2), in response to the expiration of the first period of time; and
deassert the first control signal in response to the expiration of the second period of time (T1-T2).

In an input circuit as exemplified herein (see Figure 4, for instance):

the first transistor (for instance, N0) comprises a first n-channel transistor having a drain connected to the supply voltage (for instance, Vcc), a source connected to a first node (for instance, A), and a gate connected to the first analog input node (for instance, Nin);

the second transistor comprises a second p-channel transistor (for instance, P2) having a source connected to the output node (for instance, OUT) and a gate connected to a second node (for instance, B); and

the level shifting circuitry comprises:

a first p-channel transistor (for instance, P1) having a source connected to the supply voltage, a drain connected to the second node, and a gate connected to a complement of the first control signal (for instance, CTRL1B);

a second n-channel transistor (for instance, N2) having a drain connected to a drain of the second p-channel transistor (for instance, P2), a source connected to ground, and a gate connected to the complement of the first control signal (for instance, CTRL1B);

a logic gate for instance, (13') configured to generate a logic signal as a function of a logical operation performed on the second control signal (for instance, CTRL2) and the first control signal (for instance, CTRL1);

a resistor (for instance, RO) having a first terminal connected to the first node (for instance, A); and

a third n-channel transistor (for instance, N3) having a drain connected to a second terminal of the resistor, a source connected to ground, and a gate connected to the logic signal (for instance, 13').

In an input circuit as exemplified herein (see Figure 4, for instance) the logic gate comprises a NAND gate (for instance, 13') receiving the first (for instance, CTRL1) and second (for instance, CTRL2) control signals as input and generating the logic signal as output.

In an input circuit as exemplified herein (see Figure 4, for instance) the charge circuitry comprises a third p-channel transistor (for instance, P3) having a source connected to the supply voltage (for instance, Vcc), a drain connected to the output node (for instance, OUT), and a gate connected to the second control signal (for instance, CTRL2).

Again, in an input circuit as exemplified herein, while only one channel may be active at a time, more than one channel can have a level shifter as exemplified and the circuit may further comprise (see Figure 4, for instance):

a second analog input node (for instance, Nin);

second charge circuitry (for instance, P3) configured to charge the capacitive node (for instance, C0) to the supply voltage (for instance, Vcc), during the first period of time (for instance, TO-T1);

second level shifting circuitry (for instance, P1, N1, P0, N2, 13', R0, N3) configured to discharge the capacitive node to the voltage at the second analog input node, modified by a mismatch voltage resulting from mismatch in threshold voltages between a third transistor (for instance, N0) connected to the second analog input node and a fourth transistor (for instance, P2) connected to the output node (for instance, OUT), during the second period of time (for instance, T1-T2); and

a second channel selection switch (for instance, Sx) that closes to connect the second analog input node (for instance, Nin) to the output node to thereby charge the capacitive node to the voltage at the second analog input node, the second channel selection switch being closed in response to expiration of the second period of time;

wherein the second channel selection switch opens to disconnect the second analog input node from the output node at an end (for instance, T3) of the sampling cycle of the analog to digital converter;

wherein the first channel selection switch operates based upon a first channel selection signal (for instance, ChSel<x>) that is asserted in response to expiration of the second period of time and deasserted at the end (for instance, T3) of the sampling cycle of the analog to digital converter if a first channel including the first analog input node, charge circuitry (for instance, P3), level shifting circuitry (for instance, N1, P1, N0, P2, 13', R0, P3), and first channel selection switch is selected; and

wherein the second channel selection switch operates based upon a second channel selection signal (for instance, ChSel<x>) that is asserted in response to expiration of the second period of time and deasserted at the end of the sampling cycle of the analog to digital converter if a second channel including the second analog input node, second charge circuitry (for instance, P3), second level shifting circuitry (for instance, P1, N1, P0, N2, 13', R0, N3), and second channel selection switch is selected.

An input circuit as exemplified herein (see 10' in Figure 6, for instance), not in accordance with the invention as claimed, comprises:

a first channel selection switch (for instance, S0-S7) that closes to connect a first analog input node (for instance, AnalogInput<0>-AnalogInput<7>, generically AnalogInput<x>) to an intermediate node (for instance, Nin1) to thereby charge the intermediate node to a voltage (for instance, Vin) at the first analog input node (for instance, AnalogInput<x>), the first channel selection switch being closed during a first period of time (for instance, T0-T1) beginning in response to a start (for instance, T0) of a sampling cycle of the analog to digital converter (for instance, 11);

a capacitive node (for instance, C0) connected to an output node (for instance, OUT);

discharge circuitry (for instance, N3) connected between the first channel selection switch and the output node and configured to discharge the capacitive node during the first period of time;

level shifting circuitry (for instance, P2, N2) configured to charge the capacitive node to a voltage (for instance, Vin) at the intermediate node less a threshold voltage of a first transistor (for instance, N2) of the level shifting circuitry, during a second period of time (for instance, T1-T2) beginning in response to expiration (for instance, T1) of the first period of time; and

a selection switch (for instance, SF) that closes to connect the intermediate node to the output node to thereby charge the output node to the voltage at the intermediate node, the selection switch being closed in response to expiration (for instance, T2) of the second period of time (for instance, T1-T2);

wherein the selection switch opens to disconnect the intermediate node from the output node at an end of the sampling cycle (for instance, T3) of the analog to digital converter.

An input circuit as exemplified herein (see Figure 6, for instance), not in accordance with the invention as claimed, further comprises:
a control signal generator configured to:

assert a second control signal (for instance, CTRL2), for a first period of time (for instance, T0-T1), in response to a start (for instance, T0) of the sampling cycle of the analog to digital converter (for instance, 11);

deassert the second control signal in response to an end (for instance, T1) of the first period of time;

assert a first control signal (for instance, CTRL1) for a second period of time (for instance, T1-T2), in response to the end (for instance, T1) of the first period of time; and

deassert the first control signal in response to an end (for instance, T2) of the second period of time.

In an input circuit as exemplified herein (see Figure 6, for instance), not in accordance with the invention as claimed:

the first transistor (for instance, N2) is within the level shifting circuitry (for instance, P2, N2) and comprises a first n-channel transistor (for instance, N2) having a source connected to the output node (for instance, OUT) and a gate connected to the intermediate node (for instance, Nin1); and

the level shifting circuitry (for instance, P2, N2) further comprises a first p-channel transistor (for instance, P2) having a source connected to a supply voltage (for instance, Vcc), a drain connected to a drain of the first n-channel transistor (for instance, N2), and a gate connected to the first control signal (for instance, CTRL1).

In an input circuit as exemplified herein (see Figure 6, for instance), not in accordance with the invention as claimed, the discharge circuitry comprises a second n-channel transistor (for instance, N3) having a drain connected to the output node (for instance, OUT), a source connected to ground, and a gate connected to the second control signal (for instance, CTRL2).

Again, in an input circuit as exemplified herein, not in accordance with the invention as claimed, while only one channel may be active at a time, more than one channel can be provided as exemplified and the circuit (see Figure 6, for instance), further comprises:

a second channel selection switch (for instance, S0-S7) that closes to connect a second analog input node (for instance, AnalogInput<0>-AnalogInput<7>, generically AnalogInput<x>) to the intermediate node (for instance, Nin1) to thereby charge the intermediate node to a voltage (for instance, Vin) at the second analog input node, the second channel selection switch being closed during the first period of time (for instance, T0-T1);

wherein the first channel selection switch (for instance, S0-S7) operates based upon a first channel selection signal (for instance, ChSel<x>) that is asserted in response to expiration (for instance, T2) of the second period of time (for instance, T1-T2) and deasserted at the end (for instance, T3) of the sampling cycle of the analog to digital converter (for instance, 11) if a first channel including the first analog input node (for instance, AnalogInput<x>), discharge circuitry (for instance, N3), level shifting circuitry (for instance, P2, N2), and first channel selection switch (for instance, S0-S7) is selected; and

wherein the second channel selection switch (for instance, S0-S7) operates based upon a second channel selection signal (for instance, ChSel<x>) that is asserted in response to expiration (for instance, T2) of the second period of time (for instance, T1-T2) and deasserted at the end (for instance, T3) of the sampling cycle of the analog to digital converter (11) if a second channel including the second analog input node (for instance, AnalogInput<x>), second discharge circuitry (for instance, N3), second level shifting circuitry (for instance, P2, N2), and second channel selection switch (for instance, S0-S7) is selected.

An input circuit as exemplified herein (see 10" in Figure 8, for instance), not in accordance with the invention as claimed, comprises:

a first channel selection switch (for instance, S0-S7) that closes to connect a first analog input node (for instance, AnalogInput<0>-AnalogInput<7>, generically AnalogInput<x>) to an intermediate node (for instance, Nin1) to thereby charge the intermediate node to a voltage (for instance, Vin) at the first analog input node (for instance, AnalogInput<x>), the first channel selection switch being closed during a first period of time (for instance, T0-T1) beginning in response to a start (for instance, T0) of a sampling cycle of the analog to digital converter (for instance, 11);

a capacitive node (for instance, C0) connected to an output node (for instance, OUT);

charge circuitry (for instance, P3) connected between the first channel selection switch and the output node and configured to charge the capacitive node to a supply voltage (for instance, Vcc) during the first period of time;

level shifting circuitry (for instance, P2, N2) configured to discharge the capacitive node to a voltage at the intermediate node (for instance, Vin) plus a threshold voltage of a first transistor (for instance, P2) of the level shifting circuitry during a second period of time (for instance, T1-T2) beginning in response to expiration (for instance, T1) of the first period of time; and

a selection switch (for instance, SF) that closes to connect the intermediate node (for instance, Nin1) to the output node (for instance, OUT) to thereby discharge the output node to the voltage at the intermediate node, the selection switch being closed in response to expiration of the second period of time;

wherein the selection switch opens to disconnect the intermediate node from the output node at an end (for instance, T3) of the sampling cycle of the analog to digital converter.

An input circuit as exemplified herein (see Figure 8, for instance), not in accordance with the invention as claimed, further comprises:

a control signal generator configured to:

assert a second control signal (for instance, CTRL2), for a first period of time (for instance, T0-T1), in response to a start (for instance, T0) of the sampling cycle of the analog to digital converter (for instance, 11);

deassert the second control signal in response to an end (for instance, T1) of the first period of time;

assert a first control signal (for instance, CTRL1) for a second period of time (for instance, T1-T2), in response to the end (for instance, T1) of the first period of time; and

deassert the first control signal (for instance, CTRL1) in response to an end for instance, (T2) of the second period of time.

In an input circuit as exemplified herein (see Figure 8, for instance), not in accordance with the invention as claimed:

the first transistor is within the level shifting circuitry (for instance, P2. N2) and comprises a first p-channel transistor (for instance, P2) having a source connected to the output node and a gate connected to the intermediate node (for instance, Nin1); and

the level shifting circuitry further comprises a first n-channel transistor (for instance, N2) having a drain connected to a drain of the first p-channel transistor (for instance, P2), a source connected to ground, and a gate connected to the first control signal (for instance, CTRL1).

In an input circuit as exemplified herein (see Figure 8, for instance), not in accordance with the invention as claimed, the charge circuitry comprises a second p-channel transistor (for instance, P3) having a drain connected to the output node, a source connected to the supply voltage (for instance, Vcc), and a gate connected to the second control signal (for instance, CTR2).

Again, in an input circuit as exemplified herein, not in accordance with the invention as claimed, while only one channel may be active at a time, more than one channel can be provided as exemplified and the circuit (see Figure 8, for instance) further comprises:

a second channel selection switch (for instance, S0-S7) that closes to connect a second analog input node (for instance, AnalogInput<x>) to the intermediate node (for instance, Nin1) to thereby discharge the intermediate node to a voltage (for instance, Vin) at the second analog input node (for instance, AnalogInput<x>), the second channel selection switch (for instance, S0-S7) being closed during the first period of time (for instance, T0-T1);

wherein the first channel selection switch (for instance, S0-S7) operates based upon a first channel selection signal (for instance, ChSel<x>) that is asserted in response to expiration (for instance, T2) of the second period of time (for instance, T1-T2) and deasserted at the end (for instance, T3) of the sampling cycle of the analog to digital converter (for instance, 11) if a first channel including the first analog input node (for instance, AnalogInput<x>), charge circuitry (for instance, P3), level shifting circuitry (for instance, P2, N2), and first channel selection switch (for instance, S0-S7) is selected; and

wherein the second channel selection switch (for instance, S0-S7) operates based upon a second channel selection signal (for instance, ChSel<x>) that is asserted in response to expiration (for instance, T2) of the second period of time (for instance, T1. T2) and deasserted at the end (for instance, T3) of the sampling cycle of the analog to digital converter (for instance, 11) if a second channel including the second analog input node (for instance, AnalogInput<x>), second charge circuitry (for instance, P3), second level shifting circuitry (for instance, P2, N2), and second channel selection switch (for instance, S0-S7) is selected.

An input circuit as exemplified herein (see 10''' and 10'''' in Figures 10 and 12, for instance), not in accordance with the invention as claimed, for an analog to digital converter (for instance, 11) comprises:

a first channel selection switch (for instance, S0-S7) that closes to connect a first analog input node (for instance, AnalogInput<0>-AnalogInput<7>, generically AnalogInput<x>) to an intermediate node (for instance, Nin1) to thereby charge the intermediate node to a voltage (for instance, Vin1) at the first analog input node, the first channel selection switch being closed during a first period of time (for instance, T0-T1) beginning in response to a start (for instance, T0) of a sampling cycle of the analog to digital converter;

a capacitive node (for instance, C0) connected to an output node (for instance, OUT);

a first control circuit (for instance, N3; P3) connected between the first channel selection switch and the output node and configured to set a charge at the capacitive node to a desired voltage during the first period of time (for instance, T0-T1);

a second control circuit (for instance, P0, R0, P3, 13, N0, P1, N1, P2, N2; N0, R0, N3, 13', P0, N1, P1, P2, N2) configured to set a charge at the capacitive node to a voltage (for instance, Vin) at the intermediate node (for instance, Nin1) modified by a mismatch voltage resulting from mismatch in threshold voltages between a first transistor (for instance, P0) connected to the intermediate node and a second transistor (for instance, N2) connected to the output node, during a second period of time (for instance, T1-T2) beginning in response to expiration (for instance, T1) of the first period of time; and

a selection switch (for instance, SF) that closes to connect the intermediate node (for instance, Nin1) to the output node (for instance, OUT) to thereby charge the output node to the voltage (for instance, Vin) at the intermediate node, the selection switch being closed in response to expiration (for instance, T2) of the second period of time (T1-T2);

wherein the selection switch opens to disconnect the intermediate node from the output node at an end (for instance, T3) of the sampling cycle of the analog to digital converter.

In an input circuit as exemplified herein (see Figure 10, for instance), not in accordance with the invention as claimed:

the first control circuit comprises a discharge circuitry (for instance, N3) connected between the first channel selection switch and the output node and configured to discharge the capacitive node during the first period of time; and

the second control circuit comprises level shifting circuitry (for instance, P0, R0, P3, 13, N0, P1, N1, P2, N2) configured to charge the capacitive node to the voltage at the intermediate node modified by the mismatch voltage during the second period of time.

An input circuit as exemplified herein (see 10''' in Figure 10, for instance), not in accordance with the invention as claimed, further comprises:
a control signal generator configured to:

assert a second control signal (for instance, CTRL2), for a first period of time (for instance, T0-T1), in response to a start (for instance, T0) of the sampling cycle of the analog to digital converter (for instance, 11);

deassert the second control signal in response to an end (for instance, T1) of the first period of time;

assert a first control signal (for instance, CTRL1) for a second period of time (for instance, T1-T2), in response to the end (for instance, T1) of the first period of time; and

deassert the first control signal in response to an end (for instance, T2) of the second period of time.

In an input circuit as exemplified herein (see 10‴ in Figure 10, for instance), not in accordance with the invention as claimed:

the first transistor comprises a first p-channel transistor (for instance, P0) having a source connected to a first node (for instance, A), a drain connected to ground, and a gate connected to the intermediate node (for instance, Nin1);

the second transistor comprises a second n-channel transistor (for instance, N2) having a source connected to the output node (for instance, OUT) and a gate connected to a second node (for instance, B); and

the level shifting circuitry comprises:

a first n-channel transistor (for instance, N1) having a drain connected to the second node (for instance, B), a source connected to ground, and a gate connected to the first control signal (for instance, CTRL1);

a second p-channel transistor (for instance, P2) having a source connected to a supply voltage (for instance, Vcc), a drain connected to a drain of the first n-channel transistor (for instance, N2), and a gate connected to the first control signal;

a logic gate (for instance, 13) configured to generate a logic signal as a function of a logical operation performed on the second control signal (for instance, CTRL2) and a complement of the first control signal (for instance, CTRL1B);

a resistor (for instance, R0) having a first terminal connected to the first node (for instance, A);

a third p-channel transistor (for instance, P3) having a source connected to the supply voltage (for instance, Vcc), a drain connected to a second terminal of the resistor, and a gate connected to the logic signal; and

a transmission gate (for instance, P1, N0) configured to connect the first node (for instance, A) to the second node (for instance, B) in response to assertion of the first control signal (for instance, CTRL1).

In an input circuit as exemplified herein (see 10‴ in Figure 10, for instance), not in accordance with the invention as claimed, the discharge circuitry comprises a third n-channel transistor (for instance, N3) having a drain connected to the output node (for instance, OUT), a source connected to ground, and a gate connected to the second control signal (for instance, CTRL2).

In an input circuit as exemplified herein (see 10‴ in Figure 10, for instance), not in accordance with the invention as claimed, the logic gate comprises a NOR gate (13) receiving the second control signal (for instance, CTRL2) and a complement of the first control signal (for instance, CTRL1B) as input, and generating the logic signal as output.

Again, in an input circuit as exemplified herein, not in accordance with the invention as claimed, while only one channel may be active at a time, more than one channel can be provided as exemplified and the circuit (see 10‴ in Figure 10, for instance) further comprises:

a second channel selection switch (for instance, S0-S7) that closes to connect a second analog input node (for instance, AnalogInput<x>) to the intermediate node (for instance, Nin1) to thereby charge the intermediate node to a voltage (for instance, Vin) at the second analog input node (for instance, AnalogInput<x>), the second channel selection switch (for instance, S0-S7) being closed during the first period of time (for instance, T0-T1);

wherein the first channel selection switch (for instance, S0-S7) operates based upon a first channel selection signal (for instance, ChSel<x>) that is asserted in response to expiration (for instance, T2) of the second period of time (for instance, T1-T2) and deasserted at the end (T for instance, 3) of the sampling cycle of the analog to digital converter if a first channel including the first analog input node, discharge circuitry (for instance, N3), level shifting circuitry (for instance, N1, P2, 13, R0, P3, P1, N0), and first channel selection switch is selected; and

wherein the second channel selection switch (for instance, S0-S7) operates based upon a second channel selection signal (for instance, ChSel<x>) that is asserted in response to expiration (for instance, T2) of the second period of time (for instance, T1-T2) and deasserted at the end (for instance, T3) of the sampling cycle of the analog to digital converter if a second channel including the second analog input node, second discharge circuitry (for instance, N3), second level shifting circuitry (for instance, N1, P2, 13, R0, P3, P1, N0), and second channel selection switch is selected.

In an input circuit as exemplified herein (see 10"" in Figure 12, for instance), not in accordance with the invention as claimed:

the first control circuit comprises charge circuitry (for instance, P3) connected between the first channel selection switch (for instance, S0-S7) and the output node (for instance, OUT) and configured to charge the capacitive node (for instance, C0) to a supply voltage (for instance, Vcc) during the first period of time (for instance, T0-T1); and

the second control circuit comprises level shifting circuitry (for instance, N0, R0, N3, 13', P0, N1, P1, P2, N2) configured to discharge the capacitive node to the voltage (for instance, Vin) at the intermediate node (for instance, Nin1) modified by the mismatch voltage during the second period of time (for instance, T1-T2).

An input circuit as exemplified herein (see Figure 12, for instance), not in accordance with the invention as claimed, further comprises:
a control signal generator configured to:

assert a second control signal (for instance, CTRL2), for a first period of time (for instance, T0-T1), in response to a start (for instance, T0) of a sampling cycle of the analog to digital converter (for instance, 11);

deassert the second control signal in response to an end (for instance, T1) of the first period of time;

assert a first control signal (CTRL1), for a second period of time (for instance, T1-T2), in response to the end (for instance, T1) of the first period of time; and

deassert the first control signal in response to an end (for instance, T2) of the second period of time.

In an input circuit as exemplified herein (see Figure 12, for instance), not in accordance with the invention as claimed:

the first transistor comprises a first n-channel transistor (for instance, N0) having a drain connected to the supply voltage (for instance, Vcc), a source connected to a first node (for instance, A), and a gate connected to the intermediate node (for instance, Nin1);

the second transistor comprises a second p-channel transistor (for instance, P2) having a source connected to the output node (for instance, OUT) and a gate connected to a second node (for instance, B);

a transmission gate (for instance, P0, N1) connecting the first node to the second node in response to assertion of the first control signal; and

wherein the level shifting circuitry comprises:

a first p-channel transistor (for instance, P1) having a source connected to the supply voltage (for instance, Vcc), a drain connected to the second node (for instance, B), and a gate connected to a complement of the first control signal (for instance, CTRL1B);

a second n-channel transistor (for instance, N2) having a drain connected to a drain of the second p-channel transistor (for instance, P2), a source connected to ground, and a gate connected to the complement of the first control signal (for instance, CTRL1B);

a logic gate (for instance, 13') generating a logic signal based upon a logical operation performed on the first and second control signals (for instance, CTRL1, CTRL2);

a resistor (for instance, R0) having a first terminal connected to a source of the first n-channel transistor (for instance, N0); and

a third n-channel transistor (for instance, N3) having a drain connected to a second terminal of the resistor (for instance, R0), a source connected to ground, and a gate connected to the logic signal.

In an input circuit as exemplified herein (see Figure 12, for instance), not in accordance with the invention as claimed:
the logic gate comprises a NAND gate (for instance, 13') receiving input from the first and second control signals (for instance, CTRL1, CTRL2) and generating the logic signal as output.

In an input circuit as exemplified herein (see Figure 12, for instance), not in accordance with the invention as claimed, the charge circuitry comprises a third p-channel transistor (for instance, P3) having a source connected to the supply voltage (for instance, Vcc), a drain connected to the output node (for instance, OUT), and a gate connected to the second control signal (for instance, CTRL2).

Again, in an input circuit as exemplified herein, not in accordance with the invention as claimed, while only one channel may be active at a time, more than one channel can be provided as exemplified and the circuit (see 10"" in Figure 12, for instance) further comprises:

a second channel selection switch (for instance, S0-S7) that closes to connect a second analog input node (for instance, AnalogInput<x>) to the intermediate node (for instance, Nin1) to thereby charge the intermediate node to a voltage at the second analog input node (for instance, AnalogInput<x>) during the first period of time (for instance, TO-T1);

wherein the first channel selection switch (for instance, SO-S7) operates based upon a first channel selection signal (for instance, ChSel<x>) that is asserted in response to expiration (for instance, T2) of the second period of time (for instance, T1-T2) and deasserted at the end (for instance, T3) of the sampling cycle of the analog to digital converter (for instance, 11) if a first channel including the first analog input node (for instance, AnalogInput<x>), charge circuitry (for instance, P3), level shifting circuitry (for instance, N0, R0, N3, 13', P0, N1, P1, P2, N2), and first channel selection switch (for instance, S0-S7) is selected; and

wherein the second channel selection switch (for instance, SO-S7) operates based upon a second channel selection signal (for instance, ChSel<x>) that is asserted in response to expiration (for instance, T2) of the second period of time (for instance, T1-T2) and deasserted at the end (for instance, T3) of the sampling cycle of the analog to digital converter (for instance, 11) if a second channel including the second analog input node (for instance, AnalogInput<x>), second charge circuitry (for instance, P3), second level shifting circuitry (for instance, N0, R0, N3, 13', P0, N1, P1, P2, N2), and second channel selection switch (for instance, S0-S7) is selected.

While the disclosure has been described with respect to a limited number of embodiments, those skilled in the art, having benefit of this disclosure, will appreciate that other embodiments can be envisioned that do not depart from the scope of the disclosure as disclosed herein. Accordingly, the scope of the disclosure shall be limited only by the attached claims.

## Claims

1. An input circuit for a multiplexer (10), the input circuit comprising:

   a first analog input node (Nin);
   a capacitive output node (OUT);
   a first control circuit (N3 - Fig. 2) comprising discharge circuitry (N3 - Fig. 2) configured to discharge the capacitive output node (OUT) to ground during a first period of time (T0-T1 - Fig. 3) beginning in response to a start of a sampling cycle of an analog to digital converter (11) where input to the analog to digital converter (11) is driven by output from the multiplexer (10);
   a second control circuit (N1, P1, N0, P2, N2, 13, R0, P3, P0 - Fig. 2) comprising level shifting circuitry (N1, P1, N0, P2, N2, 13, R0, P3, P0 - Fig. 2) configured to charge the capacitive output node (OUT) to a voltage at the first analog input node (Nin) during a second period of time (T1-T2 - Fig. 3) beginning in response to expiration of the first period of time (T0-T1 - Fig. 3), wherein the level shifting circuitry includes:

   a first p-channel transistor (P0 - Fig. 2) having a drain connected to ground, a source connected to a first node (A), and a gate connected to the first analog input node (Nin); and
   a second n-channel transistor (N2 - Fig. 2) having a source connected to the capacitive output node (OUT) and a gate connected to a second node (B); and

a first channel selection switch (Sx) that closes to connect the first analog input node (Nin) to the capacitive output node (OUT) to thereby drive the capacitive output node (OUT) to the voltage at the first analog input node (Nin), the first channel selection switch (Sx) being closed in response to expiration of the second period of time (T1-T2 - Fig. 3);
wherein the first channel selection switch (Sx) opens to disconnect the first analog input node (Nin) from the capacitive output node (OUT) at an end (T3 - Fig. 3) of the sampling cycle of the analog to digital converter (11);
wherein the input circuit further comprises a control signal generator configured to:

   assert a second control signal (CTRL2 - Fig. 3), for the first period of time (T0-T1 - Fig. 3), in response to the start of the sampling cycle of the analog to digital converter (11);
   deassert the second control signal (CTRL2 - Fig. 3) in response to the expiration of the first period of time (T0-T1 - Fig. 3);
   assert a first control signal (CTRL1 - Fig. 3), for the second period of time (T1-T2 - Fig. 3), in response to the expiration of the first period of time (T0-T1 - Fig. 3); and
   deassert the first control signal (CTRL1 - Fig. 3) in response to the expiration of the second period of time (T1-T2 - Fig. 3);

wherein the level shifting circuitry further comprises:

   a first n-channel transistor (N1 - Fig. 2) having a drain connected to the second node (B), a source connected to ground, and a gate connected to the first control signal (CTRL1);
   a transmission gate (P1, N0 - Fig. 2) configured to connect the first node (A) to the second node (B) in response to assertion of the first control signal (CTRL1);
   a second p-channel transistor (P2 - Fig. 2) having a drain connected to a drain of the second n-channel transistor (N2 - Fig. 2), a source connected to a supply voltage (Vcc), and a gate connected to the first control signal (CTRL1);

a logic gate (13) configured to generate a logic signal as a function of a logical operation performed on the second control signal (CTRL2) and a complement of the first control signal (CTRL1B);

a resistor (R0) having a first terminal connected to the first node (A); and

a third p-channel transistor (P3 - Fig. 2) having a drain connected to a second terminal of the resistor (R0), a source connected to the supply voltage (Vcc), and a gate connected to the logic signal (13).

2. The input circuit of claim 1, wherein the logic gate comprises a NOR gate (13) receiving the second control signal (CTRL2) and the complement of the first control signal (CTRL1B) as input, and generating the logic signal as output.

3. The input circuit of claim 1, wherein the discharge circuitry comprises a third n-channel transistor (N3 - Fig. 2) having a drain connected to the capacitive output node (OUT), a source connected to ground, and a gate connected to the second control signal (CTRL2).

4. The input circuit of claim 1, further comprising:

a second analog input node (Nin);
second discharge circuitry (N3 - Fig. 2) configured to discharge the capacitive output node (OUT) to ground during the first period of time (T0-T1 - Fig. 3);
second level shifting circuitry (P1, N0, N1, P0, P2, N2, 13, R0, P3 - Fig. 2) configured to charge the capacitive output node (OUT) to a voltage (Vin) at the second analog input node (Nin) during the second period of time (T1-T2 - Fig. 3), wherein the second level shifting circuitry includes:

a fourth p-channel transistor (P0 - Fig. 2) having a drain connected to ground, a source connected to a third node (A), and a gate connected to the second analog input node (Nin);
a fifth n-channel transistor (N2 - Fig. 2) having a source connected to the capacitive output node (OUT) and a gate connected to a fourth node (B);
a fourth n-channel transistor (N1 - Fig. 2) having a drain connected to the fourth node (B), a source connected to ground, and a gate connected to the first control signal (CTRL1);
a second transmission gate (P1, N0 - Fig. 2) configured to connect the third node (A) to the fourth node (B) in response to assertion of the first control signal (CTRL1); and
a fifth p-channel transistor (P2 - Fig. 2) having a drain connected to a drain of the fifth n-channel transistor (N2 - Fig. 2), a source connected to a supply voltage (Vcc), and a gate connected to the first control signal (CTRL1); and

a second channel selection switch (Sx) that closes to connect the second analog input node (Nin) to the capacitive output node (OUT) to thereby drive the capacitive output node (OUT) to the voltage at the second analog input node (Nin), the second channel selection switch (Sx) being closed in response to expiration of the second period of time (T1-T2 - Fig. 3);
wherein the second channel selection switch (Sx) opens to disconnect the second analog input node (Nin) from the capacitive output node (OUT) at the end (T3 - Fig. 3) of the sampling cycle of the analog to digital converter (11);
wherein the first channel selection switch (Sx) operates based upon a first channel selection signal (ChSel<x>) that is asserted in response to expiration of the second period of time (T1-T2 - Fig. 3) and deasserted at the end (T3 - Fig. 3) of the sampling cycle of the analog to digital converter (11) if a first channel including the first analog input node (Nin), discharge circuitry (N3 - Fig. 2), level shifting circuitry (N1, P1, N0, P2, N2, 13, R0, P3, P0 - Fig. 2), and first channel selection switch (Sx) is selected; and
wherein the second channel selection switch (Sx) operates based upon a second channel selection signal (ChSel<x>) that is asserted in response to expiration of the second period of time (T1-T2 - Fig. 3) and deasserted at the end (T3 - Fig. 3) of the sampling cycle of the analog to digital converter (11) if a second channel including the second analog input node (Nin), second discharge circuitry (N3 - Fig. 2), second level shifting circuitry (P1, N0, N1, P0, P2, N2, 13, R0, P3 - Fig. 2), and second channel selection switch (Sx) is selected.

5. An input circuit for a multiplexer (10), the input circuit comprising:

a first analog input node (Nin);
a capacitive output node (OUT);
a first control circuit (P3 - Fig. 4) comprising charge circuitry (P3 - Fig. 4) configured to charge the capacitive output node (OUT) to a supply voltage (Vcc) during a first period of time (T0-T1 - Fig. 5) beginning in response to a start of a sampling cycle of an analog to digital converter (11) where input to the analog to digital converter (11) is driven by output from the multiplexer (10);

a second control circuit (P1, N1, P0, N2, P2, 13', R0, N3, N0 - Fig. 4) comprising level shifting circuitry (P1, N1, P0, N2, P2, 13', R0, N3, N0) configured to discharge the capacitive output node (OUT) to the voltage (Vin) at the first analog input node (Nin) during a second period of time (T1-T2 - Fig. 5) beginning in response to expiration of the first period of time (T0-T1 - Fig. 5), wherein the level shifting circuitry includes:

a first n-channel transistor (N0 - Fig. 4) having a drain connected to the supply voltage (Vcc), a source connected to a first node (A), and a gate connected to the first analog input node (Nin); and
a second p-channel transistor (P2 - Fig. 4) having a source connected to the capacitive output node (OUT) and a gate connected to a second node (B); and

a first channel selection switch (Sx) that closes to connect the first analog input node (Nin) to the capacitive output node (OUT) to thereby drive the capacitive output node (OUT) to the voltage at the first analog input node (Nin), the first channel selection switch (Sx) being closed in response to expiration of the second period of time (T1-T2 - Fig. 5);

wherein the first channel selection switch (Sx) opens to disconnect the first analog input node (Nin) from the capacitive output node (OUT) at an end (T3 - Fig. 5) of the sampling cycle of the analog to digital converter (11);

wherein the input circuit further comprises a control signal generator configured to:

assert a second control signal (CTRL2 - Fig. 5), for the first period of time (T0-T1 - Fig. 5), in response to the start of the sampling cycle of the analog to digital converter (11);
deassert the second control signal (CTRL2 - Fig. 5) in response to the expiration of the first period of time (T0-T1 - Fig. 5);
assert a first control signal (CTRL1 - Fig. 5), for the second period of time (T1-T2 - Fig. 5), in response to the expiration of the first period of time (TO-T1 - Fig. 5); and
deassert the first control signal (CTRL1 - Fig. 5) in response to the expiration of the second period of time (T1-T2 - Fig. 5);

wherein the level shifting circuitry further comprises:

a first p-channel transistor (P1 - Fig. 4) having a source connected to the supply voltage (Vcc), a drain connected to the second node (B), and a gate connected to a complement of the first control signal (CTRL1B);
a transmission gate (N1, P0 - Fig. 4) configured to connect the first node (A) to the second node (B) in response to assertion of the first control signal (CTRL1);
a second n-channel transistor (N2 - Fig. 4) having a drain connected to a drain of the second p-channel transistor (P2 - Fig. 4), a source connected to ground, and a gate connected to the complement of the first control signal (CTRL1B);
a logic gate (13') configured to generate a logic signal as a function of a logical operation performed on the second control signal (CTRL2) and the first control signal (CTRL1);
a resistor (R0) having a first terminal connected to the first node (A); and
a third n-channel transistor (N3 - Fig. 4) having a drain connected to a second terminal of the resistor (R0), a source connected to ground, and a gate connected to the logic signal (13').

6. The input circuit of claim 5, wherein the logic gate comprises a NAND gate (13') receiving the first (CTRL1) and second (CTRL2) control signals as input and generating the logic signal as output.

7. The input circuit of claim 5, wherein the charge circuitry comprises a third p-channel transistor (P3 - Fig. 4) having a source connected to the supply voltage (Vcc), a drain connected to the capacitive output node (OUT), and a gate connected to the second control signal (CTRL2).

8. The input circuit of claim 5, further comprising:

a second analog input node (Nin);
second charge circuitry (P3 - Fig. 4) configured to charge the capacitive output node (OUT) to the supply voltage (Vcc) during the first period of time (TO-T1 - Fig. 5);
second level shifting circuitry (P1, N1, P0, N2, P2, 13', R0, N3, N0-Fig. 4) configured to discharge the capacitive output node (OUT) to the voltage (Vin) at the second analog input node (Nin) during the second period of time (T1-T2 - Fig. 5), wherein the second level shifting circuitry includes:

a fourth n-channel transistor (N0 - Fig. 4) having a drain connected to the supply voltage (Vcc), a source connected to a third node (A), and a gate connected to the second analog input node (Nin);

a fifth p-channel transistor (P2 - Fig. 4) having a source connected to the capacitive output node (OUT) and a gate connected to a fourth node (B);

a fourth p-channel transistor (P1 - Fig. 4) having a source connected to the supply voltage (Vcc), a drain connected to the fourth node (B), and a gate connected to a complement of the first control signal (CTRL1B);

a second transmission gate (N1, P0 - Fig. 4) configured to connect the third node (A) to the fourth node (B) in response to assertion of the first control signal (CTRL1); and

a fifth n-channel transistor (N2 - Fig. 4) having a drain connected to a drain of the fifth p-channel transistor (P2 - Fig. 4), a source connected to ground, and a gate connected to the complement of the first control signal (CTRL1B); and

a second channel selection switch (Sx) that closes to connect the second analog input node (Nin) to the capacitive output node (OUT) to thereby drive the capacitive output node (OUT) to the voltage at the second analog input node (Nin), the second channel selection switch (Sx) being closed in response to expiration of the second period of time (T1-T2 - Fig. 5);

wherein the second channel selection switch (Sx) opens to disconnect the second analog input node (Nin) from the capacitive output node (OUT) at an end (T3 - Fig. 5) of the sampling cycle of the analog to digital converter (11);

wherein the first channel selection switch (Sx) operates based upon a first channel selection signal (ChSel<x>) that is asserted in response to expiration of the second period of time (T1-T2 - Fig. 5) and deasserted at the end (T3 - Fig. 5) of the sampling cycle of the analog to digital converter if a first channel including the first analog input node (Nin), charge circuitry (P3 - Fig. 4), level shifting circuitry (N1, P1, P0, N2, N0, P2, 13', R0, N3 - Fig. 4), and first channel selection switch (Sx) is selected; and

wherein the second channel selection switch (Sx) operates based upon a second channel selection signal (ChSel<x>) that is asserted in response to expiration of the second period of time (T1-T2 - Fig. 5) and deasserted at the end (T3 - Fig. 5) of the sampling cycle of the analog to digital converter (11) if a second channel including the second analog input node (Nin), second charge circuitry (P3 - Fig. 4), second level shifting circuitry (P1, N1, P0, N2, N0, P2, 13', R0, N3 - Fig. 4), and second channel selection switch (Sx) is selected.

## Patentansprüche

1. Eingangsschaltung für einen Multiplexer (10), wobei die Eingangsschaltung Folgendes umfasst:

einen ersten analogen Eingangsknoten (Nin);
einen kapazitiven Ausgangsknoten (OUT);
einen ersten Steuerkreis (N3 - Fig. 2), der eine Entladeschaltung (N3 - Fig. 2) umfasst, die so konfiguriert ist, dass sie den kapazitiven Ausgangsknoten (OUT) während einer ersten Zeitspanne (T0-T1 - Fig. 3), die als Reaktion auf einen Beginn eines Abtastzyklus eines Analog-Digital-Wandlers (11) beginnt, an Masse entlädt, wobei der Eingang des Analog-Digital-Wandlers (11) durch den Ausgang des Multiplexers (10) angetrieben wird;
einen zweiten Steuerkreis (N1, P1, N0, P2, N2, 13, R0, P3, P0 - Fig. 2), der eine Pegelverschiebungsschaltung (N1, P1, N0, P2, N2, 13, R0, P3, P0 - Fig. 2) umfasst, die so konfiguriert ist, dass sie den kapazitiven Ausgangsknoten (OUT) während einer zweiten Zeitspanne (T1-T2 - Fig. 3), die als Reaktion auf den Ablauf der ersten Zeitspanne (T0-T1 - Fig. 3) beginnt, auf eine Spannung am ersten analogen Eingangsknoten auflädt, wobei die Pegelverschiebungsschaltung Folgendes enthält:

einen ersten p-Kanal-Transistor (P0 - Fig. 2), der einen Drain, der mit Masse verbunden ist, eine Source, die mit einem ersten Knoten (A) verbunden ist, und ein Gatter aufweist, das mit dem ersten analogen Eingangsknoten (Nin) verbunden ist; und
einen zweiten n-Kanal-Transistor (N2 - Fig. 2), der eine Source, die mit dem kapazitiven Ausgangsknoten (OUT) verbunden ist, und ein Gatter aufweist, das mit einem zweiten Knoten (B) verbunden ist; und
einen ersten Kanalwahlschalter (Sx), der sich schließt, um den ersten analogen Eingangsknoten (Nin) mit dem kapazitiven Ausgangsknoten (OUT) zu verbinden, um dadurch den kapazitiven Ausgangsknoten (OUT) auf die Spannung am ersten analogen Eingangsknoten (Nin) zu treiben, wobei der erste Kanalwahlschalter (Sx) als Reaktion auf den Ablauf der zweiten Zeitspanne (T1-T2 - Fig. 3) geschlossen wird;
wobei sich der erste Kanalwahlschalter (Sx) öffnet, um den ersten analogen Eingangsknoten (Nin) von dem kapazitiven Ausgangsknoten (OUT) an einem Ende (T3 - Fig. 3) des Abtastzyklus des Analog-Digital-Wandlers (11) zu trennen;

wobei die Eingangsschaltung ferner einen Steuersignalgenerator umfasst, der so konfiguriert ist, dass er:

ein zweites Steuersignal (CTRL2 - Fig. 3) für die erste Zeitspanne (T0-T1 - Fig. 3) als Reaktion auf den Beginn des Abtastzyklus des Analog-Digital-Wandlers (11) aktiviert;

das zweite Steuersignal (CTRL2 - Fig. 3) als Reaktion auf den Ablauf der ersten Zeitspanne (T0-T1 - Fig. 3) deaktiviert;

ein erstes Steuersignal (CTRL1 - Fig. 3) für die zweite Zeitspanne (T1-T2 - Fig. 3) als Reaktion auf den Ablauf der ersten Zeitspanne (T0-T1 - Fig. 3) aktiviert; und

das erste Steuersignal (CTRL1 - Fig. 3) als Reaktion auf den Ablauf der zweiten Zeitspanne (T1-T2 - Fig. 3) deaktiviert;

wobei die Pegelverschiebungsschaltung ferner Folgendes umfasst:

einen ersten n-Kanal-Transistor (N1 - Fig. 2), der einen Drain, der mit dem zweiten Knoten (B) verbunden ist, eine Source, die mit Masse verbunden ist, und ein Gatter aufweist, das mit dem ersten Steuersignal (CTRL1) verbunden ist;

ein Übertragungsgatter (P1, N0 - Fig. 2), das so konfiguriert ist, dass es als Reaktion auf das Aktivieren des ersten Steuersignals (CTRL1) den ersten Knoten (A) mit dem zweiten Knoten (B) verbindet;

einen zweiten p-Kanal-Transistor (P2 - Fig. 2), der einen Drain, der mit einem Drain des zweiten n-Kanal-Transistors (N2 - Fig. 2) verbunden ist, eine Source, die mit einer Versorgungsspannung (Vcc) verbunden ist, und ein Gatter aufweist, das mit dem ersten Steuersignal (CTRL1) verbunden ist;

ein Logikgatter (13), das so konfiguriert ist, dass es ein Logiksignal in Abhängigkeit von einer Logikoperation erzeugt, die an dem zweiten Steuersignal (CTRL2) und einer Komplementierung des ersten Steuersignals (CTRL1B) durchgeführt wird;

einen Widerstand (R0), der einen ersten Anschluss aufweist, der mit dem ersten Knoten (A) verbunden ist; und

einen dritten p-Kanal-Transistor (P3 - Fig. 2), der einen Drain, der mit einem zweiten Anschluss des Widerstands (R0) verbunden ist, eine Source, die mit der Versorgungsspannung (Vcc) verbunden ist, und ein Gatter aufweist, das mit dem Logiksignal (13) verbunden ist.

2. Eingangsschaltung nach Anspruch 1, wobei das Logikgatter ein NOR-Gatter (13) umfasst, das das zweite Steuersignal (CTRL2) und die Komplementierung des ersten Steuersignals (CTRL1B) als Eingang empfängt und das Logiksignal als Ausgang erzeugt.

3. Eingangsschaltung nach Anspruch 1, wobei die Entladeschaltung einen dritten n-Kanal-Transistor (N3 - Fig. 2) umfasst, der einen Drain, der mit dem kapazitiven Ausgangsknoten (OUT) verbunden ist, eine Source, die mit Masse verbunden ist, und ein Gatter aufweist, das mit dem zweiten Steuersignal (CTRL2) verbunden ist.

4. Eingangsschaltung nach Anspruch 1, die ferner Folgendes umfasst:

einen zweiten analogen Eingangsknoten (Nin);

eine zweite Entladeschaltung (N3 - Fig. 2), die so konfiguriert ist, dass sie den kapazitiven Ausgangsknoten (OUT) während der ersten Zeitspanne (T0-T1 - Fig. 3) entlädt;

eine zweite Pegelverschiebungsschaltung (P1, N0, N1, P0, P2, N2, 13, R0, P3 - Fig. 2), die so konfiguriert ist, dass sie den kapazitiven Ausgangsknoten (OUT) während der zweiten Zeitspanne (T1-T2 - Fig. 3) auf eine Spannung (Vin) am zweiten analogen Eingangsknoten (Nin) auflädt, wobei die zweite Pegelverschiebungsschaltung Folgendes enthält:

einen vierten p-Kanal-Transistor (P0 - Fig. 2), der einen Drain, der mit Masse verbunden ist, eine Source, die mit einem dritten Knoten (A) verbunden ist, und ein Gatter aufweist, das mit dem zweiten analogen Eingangsknoten (Nin) verbunden ist;

einen fünften n-Kanal-Transistor (N2 - Fig. 2), der eine Source, die mit dem kapazitiven Ausgangsknoten (OUT) verbunden ist, und ein Gatter aufweist, das mit einem vierten Knoten (B) verbunden ist;

einen vierten n-Kanal-Transistor (N1 - Fig. 2), der einen Drain, der mit dem vierten Knoten (B) verbunden ist, eine Source, die mit Masse verbunden ist, und ein Gatter aufweist, das mit dem ersten Steuersignal (CTRL1) verbunden ist;

ein zweites Übertragungsgatter (P1, N0 - Fig. 2), das so konfiguriert ist, dass es als Reaktion auf das Aktivieren des ersten Steuersignals (CTRL1) den dritten Knoten (A) mit dem vierten Knoten (B) verbindet; und

einen fünften p-Kanal-Transistor (P2 - Fig. 2), der einen Drain, der mit einem Drain des fünften n-Kanal-Transistors (N2 - Fig. 2) verbunden ist, eine Source, die mit einer Versorgungsspannung (Vcc) verbunden ist, und ein Gatter aufweist, das mit dem ersten Steuersignal (CTRL1) verbunden ist; und

einen zweiten Kanalwahlschalter (Sx), der sich schließt, um den zweiten analogen Eingangsknoten (Nin) mit dem kapazitiven Ausgangsknoten (OUT) zu verbinden, um dadurch den kapazitiven Ausgangsknoten (OUT) auf die Spannung am zweiten analogen Eingangsknoten (Nin) zu treiben, wobei der zweite Kanalwahlschalter (Sx) als Reaktion auf den Ablauf der zweiten Zeitspanne (T1-T2 - Fig. 3) geschlossen wird; wobei sich der zweite Kanalwahlschalter (Sx) öffnet, um den zweiten analogen Eingangsknoten (Nin) vom kapazitiven Ausgangsknoten (OUT) am Ende (T3 - Fig. 3) des Abtastzyklus des Analog-Digital-Wandlers (11) zu trennen;

wobei der erste Kanalwahlschalter (Sx) basierend auf einem ersten Kanalwahlsignal (ChSel<x>) arbeitet, das als Reaktion auf den Ablauf der zweiten Zeitspanne (T1-T2 - Fig. 3) aktiviert und am Ende behoben (T3 - Fig. 3) des Abtastzyklus des Analog-Digital-Wandlers (11) deaktiviert wird, wenn ein erster Kanal, der den ersten analogen Eingangsknoten (Nin), die Entladeschaltung (N3 - Fig. 2), die Pegelverschiebungsschaltung (N1, P1, N0, P2, N2, 13, R0, P3, P0 - Fig. 2) und den ersten Kanalwahlschalter (Sx) enthält, ausgewählt wird; und

wobei der zweite Kanalwahlschalter (Sx) basierend auf einem zweiten Kanalwahlsignal (ChSel<x>) arbeitet, das als Reaktion auf den Ablauf der zweiten Zeitspanne (T1-T2 - Fig. 3) aktiviert und am Ende (T3 - Fig. 3) des Abtastzyklus des Analog-Digital-Wandlers (11) deaktiviert wird, wenn ein zweiter Kanal, der den zweiten analogen Eingangsknoten (Nin), die zweite Entladeschaltung (N3 - Fig. 2), die zweite Pegelverschiebungsschaltung (P1, N0, N1, P0, P2, N2, 13, R0, P3 - Fig. 2) und den zweiten Kanalwahlschalter (Sx) enthält, ausgewählt wird.

5. Eingangsschaltung für einen Multiplexer (10), wobei die Eingangsschaltung Folgendes umfasst:

einen ersten analogen Eingangsknoten (Nin); einen kapazitiven Ausgangsknoten (OUT); einen ersten Steuerkreis (P3 - Fig. 4), der eine Ladeschaltung (P3 - Fig. 4) umfasst, die so konfiguriert ist, dass sie den kapazitiven Ausgangsknoten (OUT) während einer ersten Zeitspanne (T0-T1 - Fig. 5), die als Reaktion auf einen Beginn eines Abtastzyklus eines Analog-Digital-Wandlers (11) beginnt, auf eine Versorgungsspannung (Vcc) auflädt, wobei der Eingang in den Analog-Digital-Wandler (11) durch den Ausgang des Multiplexers (10) angetrieben wird;

einen zweiten Steuerkreis (P1, N1, P0, N2, P2, 13', R0, N3, N0 - Fig. 4), der eine Pegelverschiebungsschaltung (P1, N1, P0, N2, P2, 13', R0, N3, N0) umfasst, die so konfiguriert ist, dass sie den kapazitiven Ausgangsknoten (OUT) während einer zweiten Zeitspanne (T1-T2 - Fig. 5), die als Reaktion auf den Ablauf der ersten Zeitspanne (T0-T1 - Fig. 5) beginnt, auf die Spannung (Vin) am ersten analogen Eingangsknoten (Nin) entlädt, wobei die Pegelverschiebungsschaltung Folgendes umfasst:

einen ersten n-Kanal-Transistor (N0 - Fig. 4), der einen Drain, der mit der Versorgungsspannung (Vcc) verbunden ist, eine Source, die mit einem ersten Knoten (A) verbunden ist, und ein Gatter aufweist, das mit dem ersten analogen Eingangsknoten (Nin) verbunden ist; und

einen zweiten p-Kanal-Transistor (P2 - Fig. 4), der eine Source, die mit dem kapazitiven Ausgangsknoten (OUT) verbunden ist, und ein Gatter aufweist, das mit einem zweiten Knoten (B) verbunden ist; und

einen ersten Kanalwahlschalter (Sx), der sich schließt, um den ersten analogen Eingangsknoten (Nin) mit dem kapazitiven Ausgangsknoten (OUT) zu verbinden, um dadurch den kapazitiven Ausgangsknoten (OUT) auf die Spannung am ersten analogen Eingangsknoten (Nin) zu treiben, wobei der erste Kanalwahlschalter (Sx) als Reaktion auf den Ablauf der zweiten Zeitspanne (T1-T2 - Fig. 5) geschlossen wird; wobei sich der erste Kanalwahlschalter (Sx) öffnet, um den ersten analogen Eingangsknoten (Nin) von dem kapazitiven Ausgangsknoten (OUT) an einem Ende (T3 - Fig. 5) des Abtastzyklus des Analog-Digital-Wandlers (11) zu trennen;

wobei die Eingangsschaltung ferner einen Steuersignalgenerator umfasst, der so konfiguriert ist, dass er:

ein zweites Steuersignal (CTRL2 - Fig. 5) für die erste Zeitspanne (T0-T1 - Fig. 5) als Reaktion auf den Beginn des Abtastzyklus des Analog-Digital-Wandlers (11) aktiviert;

das zweite Steuersignal (CTRL2 - Fig. 5) als Reaktion auf den Ablauf der ersten Zeitspanne (T0-T1 - Fig. 5) deaktiviert;

ein erstes Steuersignal (CTRL1 - Fig. 5) für die zweite Zeitspanne (T1-T2 - Fig. 5) als Reaktion auf den Ablauf der ersten Zeitspanne (T0-T1 - Fig. 5) aktiviert; und

das erste Steuersignal (CTRL1 - Fig. 5) als Reaktion auf den Ablauf der zweiten Zeitspanne (T1-T2 - Fig. 5) deaktiviert;

wobei die Pegelverschiebungsschaltung ferner Folgendes umfasst:

einen ersten p-Kanal-Transistor (P1 - Fig. 4), der eine Source, die mit der Versorgungsspannung (Vcc) verbunden ist, einen Drain, der mit dem zweiten Knoten (B) verbunden ist, und ein Gatter auf-weist, das mit einer Komplemen-tierung des ersten Steuersignals (CTRL1B) verbunden ist;

ein Übertragungsgatter (N1, P0 - Fig. 4), das so konfiguriert ist, dass es als Reaktion auf das Aktivieren des ersten Steuersignals (CTRL1) den ersten Knoten (A) mit dem zweiten Knoten (B) verbindet;

einen zweiten n-Kanal-Transistor (N2 - Fig. 4), der einen Drain, der mit einem Drain des zweiten p-Kanal-Transistors (P2 - Fig. 4) verbunden ist, eine Source, die mit Masse verbunden ist, und ein Gatter aufweist, das mit der Komple-mentierung des ersten Steuersig-nals (CTRL1B) verbunden ist;

ein Logikgatter (13'), das so konfiguriert ist, dass es ein Logiksignal in Abhängigkeit von einer Logikoperation erzeugt, die an dem zweiten Steuersignal (CTRL2) und dem ersten Steuersignal (CTRL1) durchgeführt wird;

einen Widerstand (R0), der einen ersten Anschluss aufweist, der mit dem ersten Knoten (A) verbunden ist; und

einen dritten n-Kanal-Transistor (N3 - Fig. 4), der einen Drain, der mit einem zweiten Anschluss des Widerstands (R0) verbunden ist, eine Source, die mit Masse verbunden ist, und ein Gatter aufweist, das mit dem Logiksignal (13') verbunden ist.

6. Eingangsschaltung nach Anspruch 5, wobei das Logikgatter ein NAND-Gatter (13') umfasst, das das erste (CTRL1) und das zweite (CTRL2) Steuersignal als Eingang empfängt und das Logiksignal als Ausgang erzeugt.

7. Eingangsschaltung nach Anspruch 5, wobei die Ladeschaltung einen dritten p-Kanal-Transistor (P3 - Fig. 4) umfasst, der eine Source, die mit der Versorgungsspannung (Vcc) verbunden ist, einen Draint, der mit dem kapazitiven Ausgangsknoten (OUT) verbunden ist, und ein Gatter aufweist, das mit dem zweiten Steuersignal (CTRL2) verbunden ist.

8. Eingangsschaltung nach Anspruch 5, die ferner Folgendes umfasst:

einen zweiten analogen Eingangsknoten (Nin);

eine zweite Ladeschaltung (P3 - Fig. 4), die so konfiguriert ist, dass sie den kapazitiven Ausgangsknoten (OUT) während der ersten Zeitspanne (T0-T1 - Fig. 5) auflädt;

eine zweite Pegelverschiebungsschaltung (P1, N1, P0, N2, P2, 13', R0, N3, N0 - Fig. 4), die so konfiguriert ist, dass sie den kapazitiven Ausgangsknoten (OUT) während der zweiten Zeitspanne (T1-T2 - Fig. 5) auf die Spannung (Vin) am zweiten analogen Eingangsknoten (Nin) entlädt, wobei die zweite Pegelverschiebungsschaltung Folgendes enthält:

einen vierten n-Kanal-Transistor (N0 - Fig. 4), der einen Drain, der mit der Versorgungsspannung (Vcc) verbunden ist, eine Source, die mit einem dritten Knoten (A) verbunden ist, und ein Gate aufweist, das mit dem zweiten analogen Eingangsknoten (Nin) verbunden ist;

einen fünften p-Kanal-Transistor (P2 - Fig. 4), der eine Source, die mit dem kapazitiven Ausgangsknoten (OUT) verbunden ist, und ein Gatter aufweist, das mit einem vierten Knoten (B) verbunden ist;

einen vierten p-Kanal-Transistor (P1 - Fig. 4), der eine Source, die mit der Versorgungsspannung (Vcc) verbunden ist, einen Drain, der mit dem vierten Knoten (B) verbunden ist, und ein Gatter aufweist, das mit einer Komplementierung des ersten Steuersignals (CTRL1B) verbunden ist;

ein zweites Übertragungsgatter (N1, P0 - Fig. 4), das so konfiguriert ist, dass es als Reaktion auf das Aktivieren des ersten Steuersignals (CTRL1) den dritten Knoten (A) mit dem vierten Knoten (B) verbindet; und

einen fünften n-Kanal-Transistor (N2 - Fig. 4), der einen Drain, der mit einem Drain des fünften p-Kanal-Transistors (P2 - Fig. 4) verbunden ist, eine Source, die mit Masse verbunden ist, und ein Gatter aufweist, das mit der Komplementierung des ersten Steuersignals (CTRL1B) verbunden ist; und

einen zweiten Kanalwahlschalter (Sx), der sich schließt, um den zweiten analogen Eingangsknoten (Nin) mit dem kapazitiven Ausgangsknoten (OUT) zu verbinden, um dadurch den kapazitiven Ausgangsknoten (OUT) auf die Spannung am zweiten analogen Eingangsknoten (Nin) zu treiben, wobei der zweite Kanalwahlschalter (Sx) als Reaktion auf den Ablauf der zweiten Zeitspanne (T1-T2 - Fig. 5) geschlossen wird; wobei sich der zweite Kanalwahlschalter (Sx) öffnet, um den zweiten analogen Eingangsknoten (Nin) von dem kapazitiven Ausgangsknoten (OUT) an einem Ende (T3 - Fig. 5) des Abtastzyklus des Analog-Digital-Wandlers (11) zu trennen;

wobei der erste Kanalwahlschalter (Sx) basierend auf einem ersten Kanalwahlsignal (ChSel<x>) arbeitet, das als Reaktion auf den Ablauf der zweiten Zeitspanne (T1-T2 - Fig. 5) aktiviert und am Ende behoben (T3 - Fig. 5) des Abtastzyklus des Analog-Digital-Wandlers deaktiviert wird, wenn ein erster Kanal, der den ersten analogen Eingangsknoten (Nin), die Ladeschaltung (P3 - Fig. 4), die Pegelverschiebungsschaltung (N1, P1, P0, N2, N0, P2, 13', R0, N3 - Fig. 4) und den ersten Kanalwahlschalter (Sx) enthält, ausgewählt wird; und

wobei der zweite Kanalwahlschalter (Sx) basierend auf einem zweiten Kanalwahlsignal (ChSel<x>) arbeitet, das als Reaktion auf den Ablauf der zweiten Zeitspanne (T1-T2 - Fig. 5) aktiviert und am Ende (T3 - Fig. 5) des Abtastzyklus des Analog-Digital-Wandlers (11) deaktiviert wird, wenn ein zweiter Kanal, der den zweiten analogen Eingangsknoten (Nin), die zweite Entladeschaltung (P3 - Fig. 4), die zweite Pegelverschiebungsschaltung (P1, N1, P0, N2, N0, P2, 13', R0, N3 - Fig. 4) und den zweiten Kanalwahlschalter (Sx) enthält, ausgewählt wird.

## Revendications

1. Circuit d'entrée pour un multiplexeur (10), le circuit d'entrée comprenant :

un premier nœud d'entrée analogique (Nin) ;
un nœud de sortie capacitif (OUT) ;
un premier circuit de commande (N3 - Fig. 2) comprenant une circuiterie de décharge (N3 - Fig 2) configurée pour décharger le nœud de sortie capacitif (OUT) vers la masse pendant une première durée (T0-T1 - Fig. 3) qui débute en réponse à un démarrage d'un cycle d'échantillonnage d'un convertisseur analogique-numérique (11) où une entrée vers le convertisseur analogique-numérique (11) est excitée par une sortie du multiplexeur (10) ;
un deuxième circuit de commande (N1, P1, N0, P2, N2, 13, R0, P3, P0 - Fig. 2) comprenant une circuiterie de décalage de niveau (N1, P1, N0, P2, N2, 13, R0, P3, P0 - Fig. 2) configurée pour charger le nœud de sortie capacitif (OUT) à une tension au niveau du premier nœud d'entrée analogique (Nin) pendant une deuxième durée (T1-T2 - Fig. 3) qui débute en réponse à l'expiration de la première durée (T0-T1 - Fig. 3), dans lequel la circuiterie de décalage de niveau comporte :

un premier transistor à canal p (P0 - Fig. 2) ayant un drain connecté à la masse, une source connectée à un premier nœud (A), et une grille connectée au premier nœud d'entrée analogique (Nin) ; et
un deuxième transistor à canal n (N2 - Fig. 2) ayant une source connectée au nœud de sortie capacitif (OUT) et une grille connectée à un deuxième nœud (B) ; et
un premier commutateur de sélection de canal (Sx) qui se ferme pour connecter le premier nœud d'entrée analogique (Nin) au nœud de sortie capacitif (OUT) pour ainsi exciter le nœud de sortie capacitif (OUT) à la tension au niveau du premier nœud d'entrée analogique (Nin), le premier commutateur de sélection de canal (Sx) étant fermé en réponse à l'expiration de la deuxième durée (T1-T2 - Fig. 3) ;
dans lequel le premier commutateur de sélection de canal (Sx) s'ouvre pour déconnecter le premier nœud d'entrée analogique (Nin) du nœud de sortie capacitif (OUT) à une fin (T3 - Fig. 3) du cycle d'échantillonnage du convertisseur analogique-numérique (11) ;

dans lequel le circuit d'entrée comprend en outre un générateur de signal de commande configuré pour :

> imposer un deuxième signal de commande (CTRL2 - Fig. 3), pendant la première durée (T0-T1 - Fig. 3), en réponse au démarrage du cycle d'échantillonnage du convertisseur analogique-numérique (11) ;
> ne plus imposer le deuxième signal de commande (CTRL2 - Fig. 3) en réponse à l'expiration de la première durée (T0-T1 - Fig. 3) ;
> imposer un premier signal de commande (CTRL1 - Fig. 3), pendant la deuxième durée (T1-T2 - Fig. 3), en réponse à l'expiration de la première durée (T0-T1 - Fig. 3) ; et
> ne plus imposer le premier signal de commande (CTRL1- Fig. 3) en réponse à l'expiration de la deuxième durée (T1-T2 - Fig. 3) ;
> dans lequel la circuiterie de décalage de niveau comprend en outre :

>> un premier transistor à canal n (N1 - Fig. 2) ayant un drain connecté au deuxième nœud (B), une source connectée à la masse, et une grille connectée au premier signal de commande (CTRL1) ;
>> une grille de transmission (P1, N0 - Fig. 2) configurée pour connecter le premier nœud (A) au deuxième nœud (B) en réponse à l'imposition du premier signal de commande (CTRL1) ;
>> un deuxième transistor à canal p (P2 - Fig. 2) ayant un drain connecté à un drain du deuxième transistor à canal n (N2 - Fig. 2), une source connectée à une tension d'alimentation (Vcc), et une grille connectée au premier signal de commande (CTRL1) ;
>> une porte logique (13) configurée pour générer un signal logique en fonction d'une opération logique réalisée sur le deuxième signal de commande (CTRL2) et un complément du premier signal de commande (CTRL1B) ;
une résistance (R0) ayant une première borne connectée au premier nœud (A) ; et
un troisième transistor à canal p (P3 - Fig. 2) ayant un drain connecté à une deuxième borne de la résistance (R0), une source connectée à la tension d'alimentation (Vcc), et une grille connectée au signal logique (13).

2. Circuit d'entrée selon la revendication 1, dans lequel la porte logique comprend une porte NON-OU (13) recevant le deuxième signal de commande (CTRL2) et le complément du premier signal de commande (CTRL1B) en entrée, et générant le signal logique en sortie.

3. Circuit d'entrée selon la revendication 1, dans lequel la circuiterie de décharge comprend un troisième transistor à canal n (N3 - Fig. 2) ayant un drain connecté au nœud de sortie capacitif (OUT), une source connectée à la masse, et une grille connectée au deuxième signal de commande (CTRL2).

4. Circuit d'entrée selon la revendication 1, comprenant en outre :

> un deuxième nœud d'entrée analogique (Nin) ;
> une deuxième circuiterie de décharge (N3 - Fig. 2) configurée pour décharger le nœud de sortie capacitif (OUT) vers la masse pendant la première durée (T0-T1 - Fig. 3) ;
> une deuxième circuiterie de décalage de niveau (P1, N0, N1, P0, P2, N2, 13, R0, P3 - Fig. 2) configurée pour charger le nœud de sortie capacitif (OUT) à une tension (Vin) au niveau du deuxième nœud d'entrée analogique (Nin) pendant la deuxième durée (T1-T2 - Fig. 3), dans lequel la deuxième circuiterie de décalage de niveau comporte :

>> un quatrième transistor à canal p (P0 - Fig. 2) ayant un drain connecté à la masse, une source connectée à un troisième nœud (A), et une grille connectée au deuxième nœud d'entrée analogique (Nin) ;
>> un cinquième transistor à canal n (N2 - Fig. 2) ayant une source connectée au nœud de sortie capacitif (OUT) et une grille connectée à un quatrième nœud (B) ;
>> un quatrième transistor à canal n (N1 - Fig. 2) ayant un drain connecté au quatrième nœud (B), une source connectée à la masse, et une grille connectée au premier signal de commande (CTRL1) ;
>> une deuxième grille de transmission (P1, N0 - Fig. 2) configurée pour connecter le troisième nœud (A) au quatrième nœud (B) en réponse à l'imposition du premier signal de commande (CTRL1) ; et

un cinquième transistor à canal p (P2 - Fig. 2) ayant un drain connecté à un drain du cinquième transistor à canal n (N2 - Fig. 2), une source connectée à une tension d'alimentation (Vcc), et une grille connectée au premier signal de commande (CTRL1) ; et

un deuxième commutateur de sélection de canal (Sx) qui se ferme pour connecter le deuxième nœud d'entrée analogique (Nin) au nœud de sortie capacitif (OUT) pour ainsi exciter le nœud de sortie capacitif (OUT) à la tension au niveau du deuxième nœud d'entrée analogique (Nin), le deuxième commutateur de sélection de canal (Sx) étant fermé en réponse à l'expiration de la deuxième durée (T1-T2 - Fig. 3) ;

dans lequel le deuxième commutateur de sélection de canal (Sx) s'ouvre pour déconnecter le deuxième nœud d'entrée analogique (Nin) du nœud de sortie capacitif (OUT) à la fin (T3 - Fig. 3) du cycle d'échantillonnage du convertisseur analogique-numérique (11) ;

dans lequel le premier commutateur de sélection de canal (Sx) fonctionne sur la base d'un premier signal de sélection de canal (ChSel<x>) qui est imposé en réponse à l'expiration de la deuxième durée (T1-T2 - Fig. 3) et n'est plus imposé à la fin (T3 - Fig. 3) du cycle d'échantillonnage du convertisseur analogique-numérique (11) si un premier canal comportant le premier nœud d'entrée analogique (Nin), une circuiterie de décharge (N3 - Fig. 2), une circuiterie de décalage de niveau (N1, P1, N0, P2, N2, 13, R0, P3, P0 - Fig. 2), et un premier commutateur de sélection de canal (Sx) est sélectionné ; et

dans lequel le deuxième commutateur de sélection de canal (Sx) fonctionne sur la base d'un deuxième signal de sélection de canal (ChSel<x>) qui est imposé en réponse à l'expiration de la deuxième durée (T1-T2 - Fig. 3) et n'est plus imposé à la fin (T3 - Fig. 3) du cycle d'échantillonnage du convertisseur analogique-numérique (11) si un deuxième canal comportant le deuxième nœud d'entrée analogique (Nin), une deuxième circuiterie de décharge (N3 - Fig. 2), une deuxième circuiterie de décalage de niveau (P1, N0, N1, P0, P2, N2, 13, R0, P3 - Fig. 2), et un deuxième commutateur de sélection de canal (Sx) est sélectionné.

5. Circuit d'entrée pour un multiplexeur (10), le circuit d'entrée comprenant :

    un premier nœud d'entrée analogique (Nin) ;

    un nœud de sortie capacitif (OUT) ;

    un premier circuit de commande (P3 - Fig. 4) comprenant une circuiterie de charge (P3 - Fig 4) configurée pour charger le nœud de sortie capacitif (OUT) à une tension d'alimentation (Vcc) pendant une première durée (T0-T1 - Fig. 5) qui débute en réponse à un démarrage d'un cycle d'échantillonnage d'un convertisseur analogique-numérique (11) où une entrée vers le convertisseur analogique-numérique (11) est excitée par une sortie du multiplexeur (10) ;

    un deuxième circuit de commande (P1, N1, P0, N2, P2, 13', R0, N3, N0 - Fig. 4) comprenant une circuiterie de décalage de niveau (P1, N1, P0, N2, P2, 13', R0, N3, N0) configurée pour décharger le nœud de sortie capacitif (OUT) à la tension (Vin) au niveau du premier nœud d'entrée analogique (Nin) pendant une deuxième durée (T1-T2 - Fig. 5) qui débute en réponse à l'expiration de la première durée (T0-T1 - Fig. 5), dans lequel la circuiterie de décalage de niveau comporte :

        un premier transistor à canal n (N0 - Fig. 4) ayant un drain connecté à la tension d'alimentation (Vcc), une source connectée à un premier nœud (A), et une grille connectée au premier nœud d'entrée analogique (Nin) ; et

        un deuxième transistor à canal p (P2 - Fig. 4) ayant une source connectée au nœud de sortie capacitif (OUT) et une grille connectée à un deuxième nœud (B) ; et

        un premier commutateur de sélection de canal (Sx) qui se ferme pour connecter le premier nœud d'entrée analogique (Nin) au nœud de sortie capacitif (OUT) pour ainsi exciter le nœud de sortie capacitif (OUT) à la tension au niveau du premier nœud d'entrée analogique (Nin), le premier commutateur de sélection de canal (Sx) étant fermé en réponse à l'expiration de la deuxième durée (T1-T2 - Fig. 5) ;

        dans lequel le premier commutateur de sélection de canal (Sx) s'ouvre pour déconnecter le premier nœud d'entrée analogique (Nin) du nœud de sortie capacitif (OUT) à une fin (T3 - Fig. 5) du cycle d'échantillonnage du convertisseur analogique-numérique (11) ;

        dans lequel le circuit d'entrée comprend en outre un générateur de signal de commande configuré pour :

imposer un deuxième signal de commande (CTRL2 - Fig. 5), pendant la première durée (T0-T1 - Fig. 5), en réponse au démarrage du cycle d'échantillonnage du convertisseur analogique-numérique (11) ;

ne plus imposer le deuxième signal de commande (CTRL2 - Fig. 5) en réponse à l'expiration de la première durée (T0-T1 - Fig. 5) ;

imposer un premier signal de commande (CTRL1 - Fig. 5), pendant la deuxième durée (T1-T2 - Fig. 5), en réponse à l'expiration de la première durée (T0-T1 - Fig. 5) ; et

ne plus imposer le premier signal de commande (CTRL1- Fig. 5) en réponse à l'expiration de la deuxième durée (T1-T2 - Fig. 5) ;

dans lequel la circuiterie de décalage de niveau comprend en outre :

un premier transistor à canal p (P1 - Fig. 4) ayant une source connectée à la tension d'alimentation (Vcc), un drain connecté au deuxième nœud (B), et une grille connectée à un complément du premier signal de commande (CTRL1B) ;

une grille de transmission (N1, P0 - Fig. 4) configurée pour connecter le premier nœud (A) au deuxième nœud (B) en réponse à l'imposition du premier signal de commande (CTRL1) ;

un deuxième transistor à canal n (N2 - Fig. 4) ayant un drain connecté à un drain du deuxième transistor à canal p (P2 - Fig. 4), une source connectée à la masse, et une grille connectée au complément du premier signal de commande (CTRL1B) ;

une porte logique (13') configurée pour générer un signal logique en fonction d'une opération logique réalisée sur le deuxième signal de commande (CTRL2) et le premier signal de commande (CTRL1) ;

une résistance (R0) ayant une première borne connectée au premier nœud (A) ; et

un troisième transistor à canal n (N3 - Fig. 4) ayant un drain connecté à une deuxième borne de la résistance (R0), une source connectée à la masse, et une grille connectée au signal logique (13').

6. Circuit d'entrée selon la revendication 5, dans lequel la porte logique comprend une porte NON-ET (13') recevant les premier (CTRL1) et deuxième (CTRL2) signaux de commande en entrée et générant le signal logique en sortie.

7. Circuit d'entrée selon la revendication 5, dans lequel la circuiterie de charge comprend un troisième transistor à canal p (P3 - Fig. 4) ayant une source connectée à la tension d'alimentation (Vcc), un drain connecté au nœud de sortie capacitif (OUT), et une grille connectée au deuxième signal de commande (CTRL2).

8. Circuit d'entrée selon la revendication 5, comprenant en outre :

un deuxième nœud d'entrée analogique (Nin) ;
une deuxième circuiterie de charge (P3 -Fig. 4) configurée pour charger le nœud de sortie capacitif (OUT) à la tension d'alimentation (Vcc) pendant la première durée (T0-T1 - Fig. 5) ;
une deuxième circuiterie de décalage de niveau (P1, N1, P0, N2, P2, 13', R0, N3, N0 - Fig. 4) configurée pour décharger le nœud de sortie capacitif (OUT) à la tension (Vin) au niveau du deuxième nœud d'entrée analogique (Nin) pendant la deuxième durée (T1-T2 - Fig. 5), dans lequel la deuxième circuiterie de décalage de niveau comporte :

un quatrième transistor à canal n (N0 - Fig. 4) ayant un drain connecté à la tension d'alimentation (Vcc), une source connectée à un troisième nœud (A), et une grille connectée au deuxième nœud d'entrée analogique (Nin) ;
un cinquième transistor à canal p (P2 - Fig. 4) ayant une source connectée au nœud de sortie capacitif (OUT) et une grille connectée à un quatrième nœud (B) ;
un quatrième transistor à canal p (P1 - Fig. 4) ayant une source connectée à la tension d'alimentation (Vcc), un drain connecté au quatrième nœud (B), et une grille connectée à un complément du premier signal de commande (CTRL1B) ;
une deuxième grille de transmission (N1, P0 - Fig. 4) configurée pour connecter le troisième nœud (A) au quatrième nœud (B) en réponse à l'imposition du premier signal de commande (CTRL1) ; et
un cinquième transistor à canal n (N2 - Fig. 4) ayant un drain connecté à un drain du cinquième transistor à canal p (P2 - Fig. 4), une source connectée à la masse, et une grille connectée au complément du premier signal de commande (CTRL1B) ; et

un deuxième commutateur de sélection de canal (Sx) qui se ferme pour connecter le deuxième nœud d'entrée analogique (Nin) au nœud de sortie capacitif (OUT) pour ainsi exciter le nœud de sortie capacitif (OUT) à la tension au niveau du deuxième nœud d'entrée analogique (Nin), le deuxième commutateur de sélection de canal (Sx) étant fermé en réponse à l'expiration de la deuxième durée (T1-T2 - Fig. 5) ;

dans lequel le deuxième commutateur de sélection de canal (Sx) s'ouvre pour déconnecter le deuxième nœud d'entrée analogique (Nin) du nœud de sortie capacitif (OUT) à une fin (T3 - Fig. 5) du cycle d'échantillonnage du convertisseur analogique-numérique (11) ;

dans lequel le premier commutateur de sélection de canal (Sx) fonctionne sur la base d'un premier signal de sélection de canal (ChSel<x>) qui est imposé en réponse à l'expiration de la deuxième durée (T1-T2 - Fig. 5) et n'est plus imposé à la fin (T3 - Fig. 5) du cycle d'échantillonnage du convertisseur analogique-numérique si un premier canal comportant le premier nœud d'entrée analogique (Nin), une circuiterie de charge (P3 - Fig. 4), une circuiterie de décalage de niveau (N1, P1, P0, N2, N0, P2, 13', R0, N3 - Fig. 4), et un premier commutateur de sélection de canal (Sx) est sélectionné ; et

dans lequel le deuxième commutateur de sélection de canal (Sx) fonctionne sur la base d'un deuxième signal de sélection de canal (ChSel<x>) qui est imposé en réponse à l'expiration de la deuxième durée (T1-T2 - Fig. 5) et n'est plus imposé à la fin (T3 - Fig. 5) du cycle d'échantillonnage du convertisseur analogique-numérique (11) si un deuxième canal comportant le deuxième nœud d'entrée analogique (Nin), une deuxième circuiterie de charge (P3 - Fig. 4), une deuxième circuiterie de décalage de niveau (P1, N1, P0, N2, N0, P2, 13', R0, N3 - Fig. 4), et un deuxième commutateur de sélection de canal (Sx) est sélectionné.

## FIG. 1

## FIG. 2

## FIG. 3

## FIG. 4

## FIG. 5

## FIG. 6

## FIG. 7

# FIG. 8

FIG. 9

FIG. 10

# FIG. 11

FIG. 12

# FIG. 13

# FIG. 14

FIG. 15

# FIG. 16

EP 3 790 013 B1

**EP 3 790 013 B1**

**Patent documents cited in the description**

- US 7564394 B1

- US 20020036576 A1